Europäisches Patentamt

European Patent Office

Office européen des brevets

(19)

(11) Veröffentlichungsnummer: **0 120 458**
**B1**

(12) **EUROPÄISCHE PATENTSCHRIFT**

(45) Veröffentlichungstag der Patentschrift: **20.06.90**

(21) Anmeldenummer: **84103113.1**

(22) Anmeldetag: **21.03.84**

(51) Int. Cl.⁵: **G 06 F 11/20**

(54) Integrierter dynamischer Schreib-Lesespeicher.

(30) Priorität: **29.03.83 DE 3311427**

(43) Veröffentlichungstag der Anmeldung:
**03.10.84 Patentblatt 84/40**

(45) Bekanntmachung des Hinweises auf die
Patenterteilung:
**20.06.90 Patentblatt 90/25**

(84) Benannte Vertragsstaaten:
**AT DE FR GB IT**

(56) Entgegenhaltungen:
**EP-A-0 052 481**
**WO-A-82/02793**

**ELECTRONICS, 24. März 1982, Seiten 121-124,
NY, US; C. FURNWEGER: "Dynamic interfacing,
spare cells raise 16-K static RAM's speed and
yield"**

(73) Patentinhaber: **Siemens Aktiengesellschaft
Wittelsbacherplatz 2
D-8000 München 2 (DE)**

(72) Erfinder: **Meyer, Willibald, Dipl.-Ing.
Anette-Kolb-Anger 15
D-8000 München 83 (DE)**
Erfinder: **Wawersig, Jürgen, Ing.grad.
Plievierpark 10
D-8000 München 83 (DE)**

**Beschreibung**

Die Erfindung bezieht sich auf einen integrierten dynamischen Schreib-Lesespeicher, bei dem die aus einander gleichen Speicherzellen bestehende Speichermatrix über wenigstens einen Zeilendekoder und einen Spaltendekoder hinsichtlich der einzelnen Speicherzellen adressierbar ist, wobei die Adressierung nach den Matrixspalten jeweils durch einen Spaltenadreßtakt $\overline{CAS}$ und die Adressierung nach den Matrixzeilen jeweils durch einen Zeilenadreßtakt $\overline{RAS}$ eingeleitet wird, bei dem außerdem die Speichermatrix wenigstens eine redundante Zeile und/oder Spalte aufweist, die zunächst vom Normalbetrieb des Speichers ausgeschlossen und erst aufgrund einer besonderen Maßnahme für den Normalbetrieb—und zwar als Ersatz—verfügbar ist.

Bekanntlich beginnt bei vielen dynamischen Schreib-Lesespeichern, den sog. DRAM's, jeder Betriebszyklus mit dem Zeilenadreßtakt $\overline{RAS}$ (=row address-strobe), der sämtliche Zeilenadressen über die Adreßleitungen einliest und zwischenspeichert. Dabei wird mindestens eine der vorgesehenen Speicherzellen durch entsprechende Beaufschlagung der zugehörigen Zeilenleitungen (=Wortleitungen) auf die den einzelnen Spaltenleitungen (=Bitleitungen) zugehörenden Leseverstärker geschaltet. Letztere nehmen die in der jeweils adressierten Speicherzelle eingeschriebene digitale Information auf, die auf diese Weise zwischengespeichert und für den Datenausgang des Speichers zur Verfügung gestellt wird. Mit Beendigung des jeweiligen Auslesezyklus wird dann die zwischengespeicherte Information von dem betreffenden Leseverstärker wieder an die adressierte Speicherzelle zurückgegeben, wobei aufgrund des Zeilenadreßtakt $\overline{RAS}$ ein vom zugehörigen Spaltenadreßtakt völlig unabhängiges Auffrischen der in der betreffenden Speicherzelle eingeschriebenen Information gegeben ist.

Der zweite Teil eines jeden Zugriffs wird von dem Spaltenadreßtakt $\overline{CAS}$ (=column address-strobe) eingeleitet, der die Spaltenadressen, d.h. also die Bitleitungsadressen, einliest und abspeichert. Entsprechend dem Zeilenauswahltakt $\overline{RAS}$ wird auch durch den Spaltenadreßtakt $\overline{CAS}$ die Dekodierung gesteuert. Der Spaltenadreßtakt $\overline{CAS}$ schaltet den mit der adressierten Speicherzelle verbundenen Anschluß des Leseverstärkers auf ein Zwischenregister, das gleichzeitig dazu dient, um die Daten nochmals zu verstärken.

Nun gibt es bekanntlich auch integrierte Halbleiterspeicher, deren Matrix zusätzliche Zeilen und Spalten enthält, die zunächst für den Normalbetrieb des Speichers an sich nicht vorgesehen sind. Tritt aber an einer oder mehreren Speicherzellen, die für den Normalbetrieb vorgesehen sind, ein Defekt auf, so besteht dann die Möglichkeit, die die defekte Zelle enthaltende Zeile oder Spalte durch eine redundante Zeile oder Spalte zu ersetzen, die dann durch entsprechende Maßnahmen für den Normalbetrieb, für den sie zunächst gesperrt sind, zugänglich gemacht werden.

Hierzu ist es üblich, die redundanten Zeilen und Spalten durch entsprechende Kurzschlußverbindungen von einem Ansprechen auf den Normalbetrieb abzuhalten. Die Aktivierung erfolgt dann durch Auftrennen dieser Kurzschlußverbindungen. Solche redundante Zeilen und Spalten werden häufig (vgl. "Elektronik" (1980), H. 22, S. 93, Kap. 2.7.1) eingesetzt, da sie eine Steigerung der Ausbeute bei der Herstellung solcher Matrixspeicher ermöglichen.

Nun ist bekanntlich bei dynamischen oder bei quasistatischen RAM's, die mit redundanten Speicherzellen versehen sind und die aufgrund festgestellter defekter Speicherzellen in der soeben angedeuteten Weise "repariert" wurden, es von Bedeutung, eine Möglichkeit zu haben, bei der Serienfertigung solcher Speicher einen Chip, der einer solchen Reparatur unterworfen wurde, von einem einwandfreien Chip der gleichen Fertigungsserie unterscheiden zu könen. Außerdem kann es wichtig sein, den Fehler trotz seiner aufgrund der Reparatur erreichten Unwirksamkeit lokalisieren zu können. Es wäre nämlich erwünscht, die diese Lokalisierung betreffende Information bereits vor Durchführung des den Normalbetrieb betreffenden Tests zur Verfügung zu haben. Außerdem wäre es günstig, wenn man dabei eine Trennung der für die Adressierung der im vornherein für den Normalbetrieb geplanten Speicherzellen dienenden Signale von den zur Adressierung der einzelnen vorgesehenen redundanten Speicherzellen erforderlichen Signalen zur Verfügung hätte. Dann wäre es nämlich möglich, auch die durch den Einsatz von redundanten Zellen reparierten Speicherbausteine topologiergerecht zu prüfen und weitere Fehler leichter und besser zu analysieren.

In der Literaturstelle "Electronics" (März 24, 1982), S. 121—124, ist ein statischer RAM-Speicher beschrieben, der ebenfalls redundante Speicherzellen hat und der für die Erkennung von aktivierten redundanten Spalten einen sog. "Roll-Call-Circuit" einsetzt. Dieser Roll-Call-Kreis wird dadurch aktiviert, daß eine im Vergleich zu dem für den Normalbetrieb anzuwendenden Datenpegel größere Spannung am Dateneingangs-Pin angelegt und dann die Spaltenadressen zyklisch angewendet werden. Jedesmal, wenn dann eine durch eine redundante Spalte ersetzte Matrixspalte adressiert ist, erscheint am Datenausgang ein Signal logisch "1".

Die Aufgabe der vorliegenden Erfindung besteht nun darin, einen der eingangs gegebenen Definition entsprechenden dynamischen Schreib-Lesespeicher derart auszugestalten, daß sowohl das Vorliegen eines Ersatzes von Speicherzellen aus dem für den Normalbetrieb vorgesehenen Zellenfeld durch redundante Speicherzellen als auch die Adressen von defekten Wortleitungen wie auch von defekten Bitleitungen durch einen logischen Pegel am Datenausgang des Speichers durch Anwendung einer dem Roll-Call-Modus entsprechenden Beaufschlagung angezeigt werden.

Hierzu ist gemäß der Erfindung bei einem der eingangs gegebenen Definition entsprechenden Schreib-Lesespeicher vorgesehen, daß der aufgrund der jeweiligen Adressierung mit den eingespeicherten digitalen Daten beaufschlagte und als Tristate-Treiber ausgestaltete Datenausgang des Speichers durch den Ausgang eines weiteren und als Dekoder ausgestalteten Schaltungsteils beeinflußt wird und daß dieser Schaltungsteil derart ausgestaltet und gesteuert ist, daß bei der Adressierung jeder der durch eine redundante Zeile bzw. Spalte ersetzten Zeilen bzw. Spalten des ursprünglich für den Normalbetrieb vorgesehenen Teils der Speichermatrix und bei gleichzeitiger externer Aktivierung des als Dekoder ausgebildeten weiteren Schaltungsteils dieser eine Sperrung des normalen Datenwegs von der Speichermatrix zum Tristate-Ausgang und das Erscheinen eines entsprechenden eindeutigen Anzeigesignals am Datenausgang des Speichers bewirkt.

Es wird also eine Möglichkeit angegeben, bei einem an sich in üblicher Weise ausgestalteten dynamischen Speicher durch einen in geeigneter Weise ausgestalteten und an den Datenausgang des Speichers geschalteten Hilfsdekoder die Adressen sowohl von defekten Wortleitungen als auch von defekten Bitleitungen durch einen logischen Pegel am Datenausgang des Speichers erkennbar zu machen.

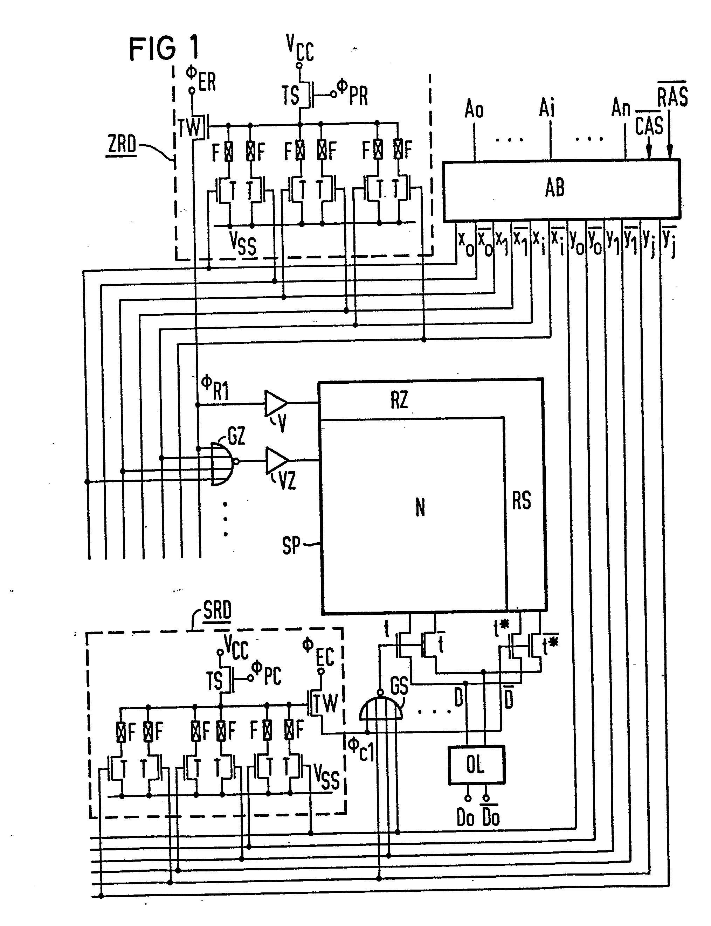

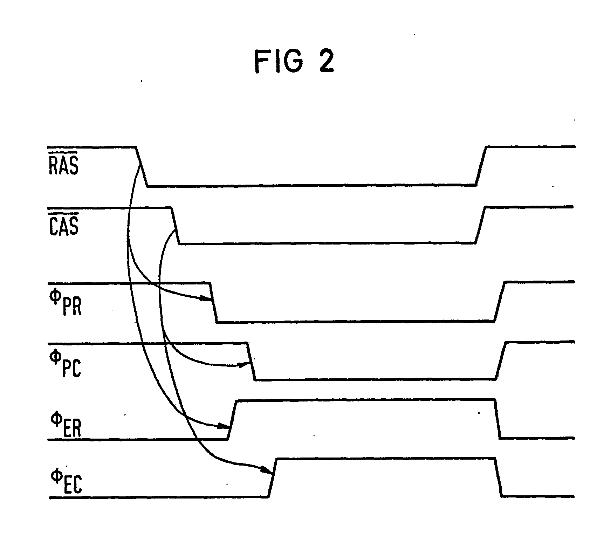

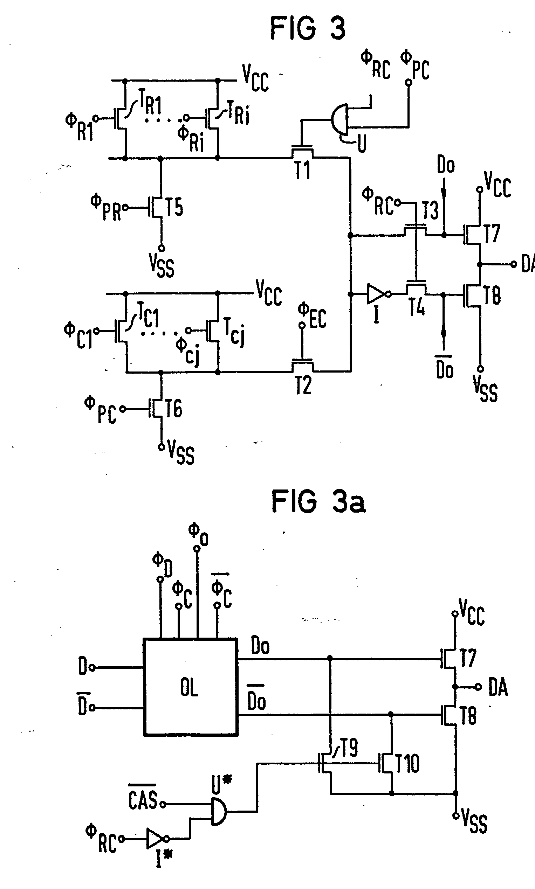

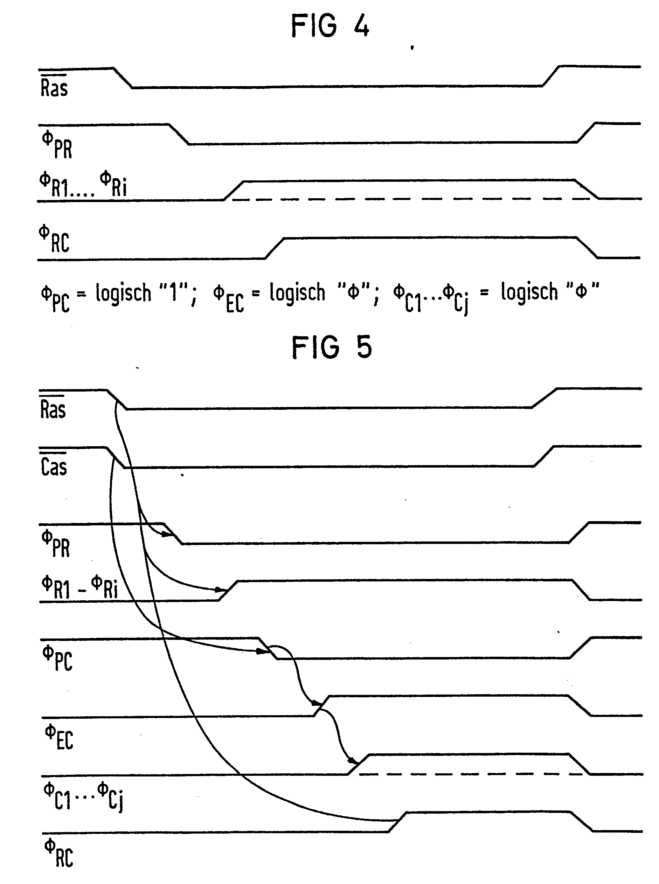

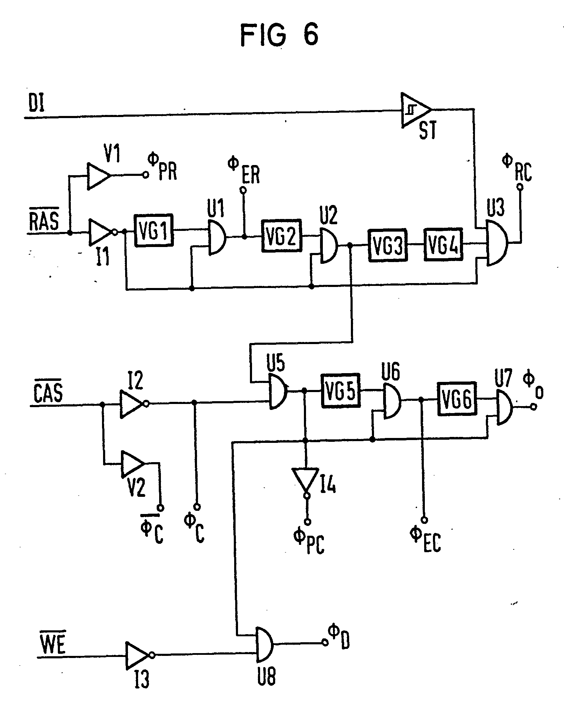

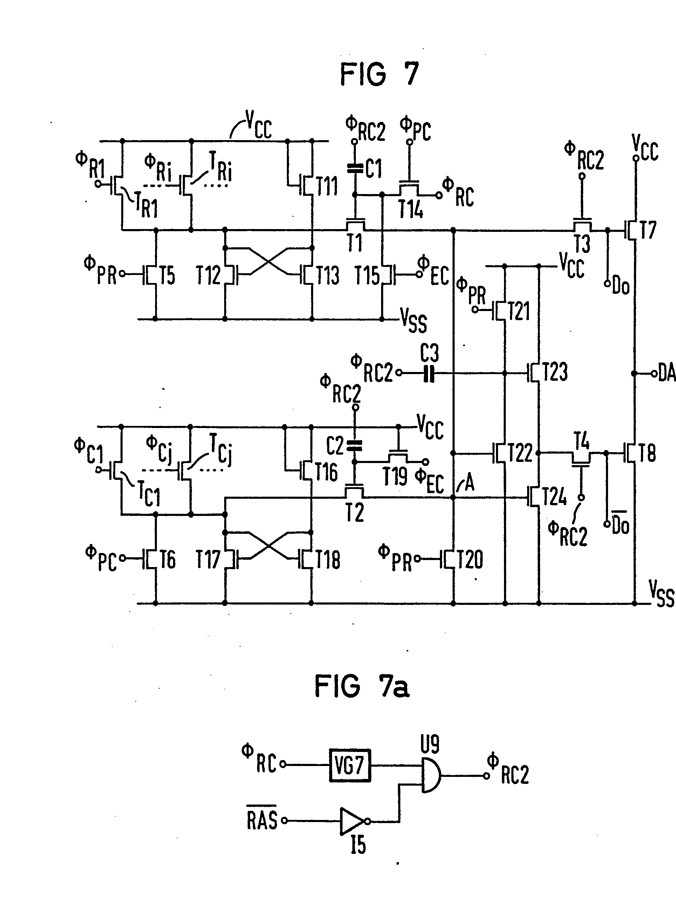

Die Erfindung wird nun anhand der Figuren 1 bis 7 näher beschrieben. Dabei ist in Figur 1 das Blockschaltbild eines üblichen dynamischen RAM-Speichers dargestellt, auf den die vorliegende Erfindung anwendbar ist. Figur 2 bringt das zugehörige Taktsteuerungs-Zeitdiagramm. Figur 3 stellt den Schaltplan für einen der Erfindung entsprechenden Dekoder dar, während Figur 3a die für den Normalbetrieb anzuwendende und ebenfalls auf den Tristateausgang geschaltete Datenausgangsschaltung des Speichers zeigt. Figur 4 bringt das Zeitdiagramm der für den Betrieb des Dekoders gemäß Figur 3 erforderlichen Impulse und Figur 5 das Zeitdiagramm der für den Roll-Call im Early-Write-Betrieb anzuwendenden Impulse. In Figur 6 ist das Blockschaltbild eines die für den Betrieb einer Anlage gemäß der Erfindung liefernden und von den Impulsen $\overline{RAS}$, $\overline{CAS}$ und $\overline{WE}$ (=Schreibtakt), also von den bei dynamischen RAM-Speichern üblichen Impulsen gesteuerten Taktumformers dargestellt. In Figur 7 ist eine weitere Ausgestaltung des den Kern der Erfindung bildenden Ausgangsdekoders gezeigt.

Der in Figur 1 im Blockschaltbild dargestellte DRAM-Speicher ist mit redundanten Zeilen und Spalten versehen und verwendet eine Kontrollschaltung, wie sie in "1981 IEEE International Solid-State Circuits Conference", S. 84 und 85, in Figur 3 dargestellt ist. Sie ist jedoch im Vergleich zu der genannten Veröffentlichung in Figur 1 noch eingehender dargestellt. Der für den Normalbetrieb beabsichtigte Teil der Speichermatrix SP ist mit N, der Bereich der redundanten Zeilen mit RZ und der Bereich der redundanten Spalten mit RS bezeichnet. Von den Adreßeingängen $A_0$, $A_1$,...$A_n$

her wird ein sowohl vom Spaltenadreßtakt $\overline{CAS}$ als auch vom Zeilenadreßtakt $\overline{RAS}$ gesteuerter und als Demultiplexer ausgebildeter Adreßbuffer AB beaufschlagt, dessen mit $x_i$ bzw. $\overline{x}_i$ ($i=0, 1, 2,...$) bezeichnete Ausgänge für die Adressierung nach den Matrixzeilen und dessen mit $y_j$ bzw. $\overline{y}_j$ ($j=0, 1, 2,...$) für die Adressierung nach den Matrixspalten—und zwar zunächst nur für das für den Normalbetrieb vorgesehene Zellenfeld N—zuständig sind. Hierzu sind jeweils zwei Adressierungsausgänge für die Zeilenansteuerung (also je zwei Ausgänge $x_i$, $\overline{x}_i$) als auch jeweils zwei Adressierungsausgänge für die Spaltenansteuerung (also zwei Ausgänge $y_j$, $\overline{y}_j$) zu einem Paar zusammengefaßt, indem sie zueinander invertierte Adressiersignale führen.

Die für die Adressierung nach den Zeilen des für den Normalbetrieb vorgesehenen und z.B. quadratischen Teils N der Speichermatrix SP vorgesehenen Ausgangspaare $x_0$, $\overline{x}_0$...$x_n$, $\overline{x}_n$ sind mit jeweils n Eingängen der den einzelnen Matrixzeilen zugeordneten NOR-Gatter GZ so verbunden, daß für jede mögliche Kombination von Signalen an den Adreßeingängen $A_0$,...$A_n$ des Adreßbuffers AB jeweils genau eine der Matrixzeilen im Bereich N der Speichermatrix SP durch den Ausgang des zugehörigen NOR-Gatters GZ unter Verwendung eines Verstärkers V aktiviert wird.

Die für die Adressierung nach den Spalten des für den Normalbetrieb vorgesehenen Teil N der Speichermatrix vorgesehenen Ausgänge $y_j$, $\overline{y}_j$ des Adreßbuffers AB sind in ihrer Gesamtheit ebenfalls zur Steuerung von—nunmehr mit GS bezeichneten—NOR-Gattern vorgesehen, wobei den einzelnen Matrixspalten und damit Bitleitungen in dem für den Normalbetrieb vorgesehenen Zellenfeld N der Speichermatrix SP jeweils ein solches NOR-Gatter GS zugeordnet ist. Auch hier ist in Analogie zur Zeilenansteuerung jedem Ausgangspaar $y_j$, $\overline{y}_j$ der ein Eingang jedes dieser NOR-Gatter GS zugeteilt. Allerdings ist die Ansteuerung der Spalten des Zellenfelds N durch die NOR-Gatter GS etwas anders als die Ansteuerung der Matrixzeilen durch die NOR-Gatter GZ.

Dies liegt daran, daß die Speicherzellen und Vergleichszellen der Speichermatrix SP als einander gleiche Eintransistorspeicherzellen ausgebildet sind, wobei die zu jeweils einer Matrixzeile gehörenden Zellen mit dem Gate ihres Transistors an die der betreffenden Matrixzeile zugeordnete Wortleitung gelegt ist. Anders ist die Situation bezüglich der Spaltenleitungen, also der Bitleitungen. Jede dieser Bitleitungen ist (vgl. z.B. "1976 IEEE International Solid-State-Circuits Conference", S. 128 und 129) in zwei Hälften unterteilt, die jeweils die Hälfte der pro Matrixspalte vorgesehenen Speicherzellen und je eine Vergleichszelle (Dummzelle) aufweisen und an dem der Speicherkapazität der betreffenden Zelle abgewandten stromführenden Anschluß des Schalttransistors der betreffenden Zelle angeschlossen sind, während der andere stromführende Anschluß des Schalttransistors mit der auf ein Bezugspotential bezogenen Speicherkapazität verbunden ist. Jede der beiden Bitleitungshälften ist mit ihrem einen Ende an je einem der beiden Signalanschlüsse des als Flip-Flop ausgebildeten Schreib-Leseverstärker der betreffenden Matrixspalte angeschlossen, während am anderen Ende die Adressierung erfolgt.

Aus diesem Grunde sind die aus Figur 1 ersichtlichen Abweichungen hinsichtlich der Anschaltung der der Adressierung nach den Matrixspalten dienenden NOR-Gatter GS im Vergleich zu den der Adressierung nach den Matrixzeilen dienenden NOR-Gattern GZ vorgenommen. Der Ausgang jedes dieser NOR-Gatter GS steuert das Gate jeweils zweier MOS-Feldeffekttransistoren t, $\bar{t}$, deren einer stromführender Anschluß (Source) an je einen der beiden informationsführenden und mit je einer Bitleitungshälfte der zugehörigen Matrixspalte verbundenen Anschlüsse des Schreib-Leseverstärkers gelegt ist, der der durch das betreffende NOR-Gatter GS jeweils zu adressierenden Matrixspalte zugeordnet ist. Der andere stromführende Anschluß des einen dieser beiden MOS-FET's, d.h. des Transistors t, liegt an dem das nichtinvertierte Ausgangssignal führenden Datenausgang D und der des anderen MOS-FET's $\bar{t}$ an dem das invertierte Ausgangssignal führenden Datenausgang $\bar{D}$ der Speichermatrix.

Da die Speichermatrix SP redundante Zeilen und Spalten enthält, die im Aufbau den in dem Teil N der Speichermatrix SP vorgesehenen Spalten und Zeilen gleich sind und die im Bedarfsfall je eine schadhafte Zeile oder Spalte des Normalbereichs N zu ersetzen haben, sind zu diesem Zweck noch weitere Schaltungsteile vorgesehen, die wenigstens einen Zeilenredundanzdekoder ZRD bzw. einen Spaltenredundanzdekoder SRD bilden.

Bei jedem der vorgesehenen Zeilenredundanzdekoder ZRD ist jedem der der Adressierung nach den Matrixzeilen zugeordneten Adreßausgängen $x_i$, $\bar{x}_i$ des Adreßbuffers AB je ein MOS-Feldeffekttransistor T zugeordnet, indem dessen Gate mit dem betreffenden Adreßausgang des Adreßbuffers AB verbunden ist. Die Gesamtheit der Sourceanschlüsse dieser Transistoren T liegt am Bezugspotential $V_{ss}$ und ihre Drains über je eine auftrennbare Verbindung F gemeinsam an der Source eines durch einen Takt $\emptyset_{PR}$ gesteuerten weiteren MOS-Feldeffekttransistors TS. Dieser liegt mit seinem Drain an dem ersten Versorgungspotential $V_{cc}$ und mit seinem Sourceanschluß nicht nur an den auftrennbaren Verbindungen F sondern auch noch am Gate eines weiteren MOS-Feldeffekttransistors TW. Dies Source dieses weiteren Transistors TW ist zur Steuerung je eines weiteren Eingangs jedes der zur Zeilenauswahl vorgesehenen NOR-Gatters GZ bestimmt.

Hierzu wird der Drainanschluß dieses weiteren Transistors TW durch ein getaktetes Drainpotential $\emptyset_{ER}$ beaufschlagt. Der Sourceanschluß dieses weiteren Transistors TW ist schließlich einerseits an je einen Eingang der für die Steuerung der einzelnen Wortleitungen und damit für die Adressierung nach den Zeilen im normalen Zellenfeld N zuständigen NOR-Gatter GZ als auch über einen Verstärker V an je eine redundante Wortleitung in dem Ergängzungsteil RZ der Speicherzellenmatrix SP gelegt. Jede der vorgesehenen redundanten Zeilen und damit Wortleitungen ist auf die aus Figur 1 ersichtliche Weise mit je einem Zeilenredundanzdekoder ZRD verbunden, wobei die vorgesehenen Zeilenredundanzdekoder ZRD bezüglich ihrer Schaltung identisch sind. Die Taktsignale $\emptyset_{ER}$ zur Steuerung des Drainanschlusses der Transistoren TW sowie die Taktsignale $\emptyset_{PR}$ zur Steuerung des Gates des Transistors TS sind für alle Zeilenredundanzdekoder ZRD des Speichers gemeinsam.

Wie man leicht erkennt, wird jede der für den Normalbetrieb vorgesehenen Wortleitungen, also jede Wortleitung im Zellenfeld N, dann und nur dann mit dem Pegel "1" beaufschlagt, wenn an sämtlichen Eingängen des zugehörigen NOR-Gatters GZ eine "0" anhängig ist. Aufgrund der oben gemachten Feststellungen ist dies jeweils nur bei einer einzigen bestimmten Kombination der an den Ausgängen $x_i$, $\bar{x}_i$ des Adreßbuffers AB aufgrund der möglichen Adressierung der Fall sein. Außerdem müssen dann sämtliche auftrennbaren Verbindungen F in dem jeweils einer redundanten Zeile im Zellenfeld RZ jeweils zugeordneten Redundanzdekoder ZRD in Ordnung sein.

Soll nun eine vorgesehene Matrixzeile im Zellenfeld N durch eine redundante Zeile ersetzt werden, so muß der der betreffenden redundanten Zeile jeweils zugeordnete Redundanzdekoder ZRD so durch Auftrennen von Verbindungen F fest programmiert werden, daß beim Auftreten der der betreffenden Zeile im Zellenfeld N zugeordneten Zeilen-Adreßkombination an den Ausgängen $x_i$, $\bar{x}_i$ des Adreßbuffers AB das dieser Zeile im Zellenfeld N jeweils zugeordnete NOR-Gatter GZ gesperrt wird und statt dessen der Transistor TW in dem der redundanten Zeile zugeordneten Zeilenredundanzdekoder den Takt $\emptyset_{ER}$ an die der redundanten Zeile zugeordnete Wortleitung im Zellenfeld RZ durchschaltet. Diesbezügliche Einzelheiten werden noch gebracht, da hier Übereinstimmung mit der Adressierung redundanter Matrixspalten gegeben ist. Vorerst wird jedoch noch kurz auf die Anschaltung der Spaltenadressierung eingegangen.

Jeder Matrixspalte in dem für den Normalbetrieb vorgesehenen Zellenfeld N ist ebenfalls, wie bereits bemerkt, je ein als Spaltenadreßdekoder wirksames NOR-Gatter GS zugeordnet, dessen Eingänge durch die der Spaltenadressierung dienenden Adreßausgänge $y_j$, $\bar{y}_j$ jeweils derart beaufschlagt sind, daß jeweils nur bei einer der betreffenden Matrixspalten allein zugeordneten Adreßkombination am Ausgang des der betreffenden Matrixspalte zugeordneten NOR-Gatters GS eine "1" erscheint. Diese "1" dient dann der Adressierung der betreffenden Matrixspalte im Zellenfeld N. Da nun bei dynamischen Speichern mit Eintransistors-Speicherzellen die Bitleitung aus zwei an je einem der beiden Signalanschlüsse des bereits erwähnten Schreib-Leseverstärkers gelegten Hälften besteht, müssen beide Teile für sich adressiert werden. Aus diesem Grund sind die beiden Signalanschlüsse des den einzelnen Matrixspalten jeweils zugeordneten Schreib-Leseverstärkers über die Source-Drainstrecke je eines Transistors t bzw. $\bar{t}$ an je einen der beiden Datenausgänge D bzw. $\bar{D}$ gelegt. Die Gates dieser beiden der betreffenden Matrixspalte jeweils zugeordneten Transistoren t, $\bar{t}$ werden von dem Ausgang des der betreffenden Matrixspalte zugeordneten NOR-Gatters GS beaufschlagt und gesteuert. Diese Sachlage ist bereits oben festgestellt worden.

Nun ist auch jeder redundanten Matrixspalte im Bereich RS je ein solches MOS-Transistorpaar t*$\bar{t}$* zugeordnet, das in derselben Weise wie die Transistoren t bzw. $\bar{t}$ an die zugehörige Matrixspalte angeschlossen sind. Das das betreffende MOS-Transistorpaar t*, $\bar{t}$* ansteuernde Signal wird jedoch nicht von einem NOR-Gatter GS sondern vom Ausgang eines—nur der betreffenden redundanten Matrixspalte jeweils zugeordneten—Spalten-Redundanzdekoders SRD geliefert. Dies bedeutet, daß jede der vorgesehenen redundanten Matrixspalten jeweils mit einem ihr zugeordneten Spalten-Redundanzdekoder SRD kombiniert ist.

Im Aufbau stimmen in Fig. 1 die vorgesehenen Spalten-Redundanzdekoder SRD mit den Zeilen-Redundanzdekodern ZRD überein, so daß übereinstimmende Bezugszeichen in beiden Fällen verwendet sind. Der die Verbindung des Gates des Ausgangstransistors TW mit dem Versorgungspotential $V_{cc}$ bildende Transistor TS wird bei allen Spalten-Redundanzdekodern SRD gemeinsam durch ein Taktsignal $\emptyset_{PC}$ gesteuert, das vom entsprechenden Taktsignal $\emptyset_{PR}$ bei den Zeilen-Redundanzdekodern ZRD, wie aus Figur 2 hervorgeht, zeitlich abweicht. Dasselbe gilt für den den Drainanschluß des Ausgangstransistors TW in den vorgesehenen Spalten-Redundanzdekodern SRD bei allen diesen Dekodern gemeinsam beaufschlagenden Taktimpuls $\emptyset_{EC}$ inbezug auf das entsprechende Taktsignal $\emptyset_{PR}$ bei den Zeilen-Redundanzdekodern ZRD. Schließlich ist noch zu bemerken, daß der durch das Source des Ausgangstransistors TW des einzelnen Spalten-Redundanzdekoders SRD gegebene Ausgang desselben an je einen Eingang aller der für die Spaltenadressierung zuständigen NOR-Gatter GS gelegt ist.

Die Zeitdiagramme der zum Betrieb eines DRAM-Speichers gemäß Fig. 1 erforderlichen Taktsignale sind in Fig. 2 dargestellt.

Um nun eine für den Normalbetrieb im Zellenfeld N vorgesehene Matrixspalte durch eine zur Verfügung stehende redundante Spalte zu ersetzen muß in Analogie zu den Verhältnissen bei dem Ersatz von Matrixzeilen durch je eine redundante Zeile der der betreffenden Matrixspalte zugeordnete Redundanzdekoder durch Unterbrechung von Verbindungstellen F jeweils so eingestellt werden, daß beim Adressieren der im für den Normalbetrieb zuständigen Zellenfeld N zu ersetzenden Spalte einer der Spalten-Redundanzdekoder SRD anspricht und ein Signal $\emptyset_{cj}$ liefert,

welches eine redundante Spalte aktiviert und gleichzeitig alle übrigen Spalten der normalen Speichermatrix N und damit auch die defekten Spalten deaktiviert.

Zu erwähnen ist noch, daß die beiden Datenausgänge D und $\bar{D}$ des Speichers bevorzugt über einen Ausgangstreiber OL an einen Tristateausgang geführt sind, wie dies in der Patentanmeldung P 32 43 496.0 (=VPA 82 P 2022) näher beschrieben ist. In Fig. 1 und weiteren Figuren sind die Datenausgänge des Ausgangstreibers OL mit Do bzw. $\overline{Do}$ bezeichnet.

Um nun den bekannten DRAM-Speicher gemäß Figur 1 entsprechend der vorliegenden Erfindung weiter auszugestalten, wird gemäß der Definition der vorliegenden Erfindung der als Tristateausgang ausgebildete Datenausgang durch den Ausgang eines weiteren und als Dekoder ausgestalteten Schaltungsteils beeinflußt und dieser Schaltungsteil so ausgestaltet, daß er als Roll-Call-Dekoder wirkt. Die Ausgestaltung wird vorteilhafter Weise in der aus Figur 3 ersichtlichen Weise vorgenommen. Da der zu steuernde Tristateausgang auch von den dem Speicher zu entnehmenden Daten passiert wird, ist es zweckmäßig den Tristateausgang in der aus Fig. 3a ersichtlichen Weise an den Datenausgangsbuffer OL des Speichers anzuschließen.

Figur 4 und Figur 5 zeigen die für die beiden Betriebsarten des in Figur 3 dargestellten Roll-Call-Dekoders erforderlichen Taktimpulse im Zeitdiagramm, während in Figur 6 das Schaltbild einer für die Erzeugung der zum Betrieb des Roll-Call-Dekoders gemäß Fig. 3 erforderlichen Impulse geeigneten Anlage gezeigt ist. Eine zweckmäßige Darstellung des erfindungsgemäßen Roll-Call-Dekoders, die etwas von der Ausbildung gemäß Figur 3 abweicht und und ebenfalls in MOS-Technik dargestellt ist, bildet den Gegenstand der Figur 7 und die hierzu erforderliche Ergänzung des Impulsformers gemäß Figur 6 den Gegenstand der Figur 7a. Lediglich die Erzeugung der Impulse $\overline{RAS}$, $\overline{CAS}$ und $\overline{WE}$ ist in den Zeichnungen nicht dargestellt, da hierzu etliche Anlagen bekannt sind.

Das in Figur 3 gezeigte Schaltbild stellt einen sog. Roll-Call-Dekoder dar, weil die mit seiner Hilfe mögliche Betriebsart eines DRAM-Speichers gemäß Fig. 1 dem an sich bekannten (vgl. Electronics/March 24, 1982, S. 121—124) Roll-Call-Modus entspricht. Während es sich beim Bekannten jedoch um den Einsatz dieses Modus bei einem statischen RAM handelt und der Betrieb dort ausschließlich auf einen Speicher abgestimmt ist, der nur redundante Bitleitungen, jedoch keine redundanten Wortleitungen aufweist, und bei dem außerdem die Adressen nicht gemultiplext sind, sollen im vorliegenden Fall diese Beschränkungen zum Wegfall kommen.

Der in Figur 3 dargestellte Roll-Call-Dekoder ist (ebenso wie die übrige Speicherschaltung) mit Hilfe von selbstsperrenden MOS-Feldeffekttransistoren vomselben Kanaltyp, aufgebaut, so daß die Integration zusammen mit den übrigen Teilen des Speichers, insbesondere auch mit der erforderlichen Impulsformeranlage gemäß Figur 6, keine besonderen technologischen Schwierigkeiten bereitet. Im Interesse der höheren Schaltgeschwindigkeit ist die Verwendung von n-Kanal MOS-FET's für die Realisierung günstiger als die von p-Kanal-MOS-FET's. Die Schaltdiagramme und die angegebenen Spannungen sind deshalb auf den erstgenannten Fall ausgerichtet.

Zum Zwecke der Steuerung des in Fig. 3 dargestellten Dekoders gemäß der vorliegenden Erfindung ist zunächst der das auszuwertende Datensignal liefernde Signalausgang Do zur Steuerung eines ersten Ausgangstransistors T7 und der das hierzu invertierte Ausgangssignal liefernde Datenausgang $\overline{Do}$ zur Steuerung eines zweiten Ausgangstransistors T8 vorgesehen. Dabei liegt der durch den direkten Ausgang Do des Speichers gemäß Fig. 1 gesteuerte Transistor T7 mit seinem Drain am ersten Versorgungspotential $V_{cc}$ und mit seinem Sourceanschluß an der Signalausgangsklemme DA des DRAM-Speichers. Der durch das invertierte Ausgangs-Datensignal und damit durch den Ausgang $\overline{Do}$ des Speichers gesteuerte Transistor T8 liegt mit seinem Sourceanschluß an dem als Bezugspotential verwendeten zweiten Versorgungspotential $V_{ss}$ und mit seinem Drain ebenfalls an der Signalausgangsklemme DA, so daß die beiden Ausgangstransistoren T7 und T8 bezüglich ihrer Source-Drainstrecken in Reihe geschaltet sind. Da die beiden Ausgangstransistoren vomselben Kanaltyp sind, bilden sie einen sog. Tristate-Ausgang, der in üblicher Weise durch den Ausgangstreiber OL der in Figur 1 dargestellten Speicherschaltung für einen dynamischen integrierten Halbleiterspeicher gesteuert ist, wobei die aus Fig. 3a ersichtliche Beaufschlagungsart sich besonders empfiehlt. Wesentlich für die Erfindung ist nun eine zusätzliche und vom Betriebszustand von redundanten Zeilen bzw. Spalten abhängige, zusätzliche Steuerung des Tristate-Ausgangs T7, T8.

Wie bereits dargelegt, ist jeder der vorgesehenen redundanten Zeilen in der Speichermatrix SP je ein Zeilen-Redundanzdekoder ZRD zugeordnet. Der Ausgang des jeweiligen Zeilen-Redundanzdekoders ZRD ist durch den Sourceanschluß des an seinem Drain durch den für alle Zeilen-Redundanzdekoder der Schaltung gemeinsamen Takt $\emptyset_{ER}$ beaufschlagten Transistors TW dieser Redundanzdekoder ZRD gegeben. Dieser Ausgang führt infolge einer Durchtrennung von Trennelementen F in dem betreffenden Dekoder ein aufgrund der Durchtrennung programmiertes Signal $\emptyset_{Ri}$. Dieses Signal $\emptyset_{Ri}$ wird, wie aus Fig. 1 ersichtlich, zur Adressierung der dem i-ten Zeilen-Redundanzdekoder $ZRD_i$ zugehörigen i-ten redundanten Wortleitung im Teil RZ der Speichermatrix SP verwendet. Es dient aber außerdem noch zu Steuerung je eines Transistors $T_{Ri}$ im Roll-Call-Dekoder gemäß Figur 3.

Die Gesamtheit dieser durch je einen der vorgesehenen Zeilen-Redundanzdekoder $ZRD_i$ gesteuerten Transistoren $T_{Ri}$ (i=1, 2,...) ist mit dem Drainanschluß an das erste Versorgungspotential $V_{cc}$ und mit den Sourceanschlüssen gemeinsam an den Drainanschluß eines weiteren MOS-Feldeffekttransistors T5 gelegt, der die Verbindung zum Bezugspotential $V_{ss}$ bildet und durch dasselbe Taktsignal $\emptyset_{PR}$ gesteuert werden kann, das auch an dem Gate des den Anschluß zum Versorgungspotential $V_{cc}$ bildenden MOS-Feldeffekttransistors TS in den einzelnen Zeilen-Redundanzdekodern ZRD liegt. Der zwischen den Transistoren $T_{Ri}$ und dem Transistor T5 liegende gemeinsame Knoten ist über die Source-Drainstrecke eines weiteren MOS-Feldeffekttransistors T1 zur Steuerung des Tristate-Ausgangs T7, T8 vorgesehen. Dabei ist zunächst festzustellen, daß das Gate dieses weiteren MOS-FET's T1 durch den Ausgang eines UND-Gatters U kontrolliert wird, das seinerseits durch zwei Taktfolgen $\emptyset_{RC}$ und $\emptyset_{PC}$ gesteuert ist. Dabei ist die Taktfolge $\emptyset_{PC}$ diejenige Taktfolge, die gemeinsam bei den vorgesehenen Spalten-Redundanzdekodern $SRD_j$ (j=1, 2,...) das Gate des die Verbindung der in den betreffenden Spalten-Redundanzdekodern jeweils vorgesehenen Auftrennstellen F zum ersten Versorgungspotential $V_{cc}$ bildenden gemeinsamen MOS-Feldeffekttransistor TS steuert.

Die andere für die Steuerung des UND-Gatters U vorgesehene Impulsfolge $\emptyset_{RC}$ ist hingegen bei der in Figur 1 dargestellten Schaltung bei den dort vorgesehenen Schaltungsteilen nicht verwendet. Sie ist hingegen für den Betrieb des Roll-Call-Dekoders gemäß Fig. 3 erforderlich und hat den aus Figur 4 bzw. Figur 5 ersichtlichen zeitlichen Verlauf. Der Drain des durch das UND-Gatter U gesteuerten Transistors T1 ist gemeinsam mit dem Drain eines zweiten MOS-Feldeffekttransistors T2 zur Steuerung des Tristate-Ausgangs unter Vermittlung eines noch zu beschreibenden Schaltungsteils vorgesehen.

Ebenso wie den einzelnen Zeilen-Redundanzdekodern ist auch jedem der vorgesehenen Spalten-Redundanzdekoder $SRD_j$ je ein MOS-Feldeffekttransistor $T_{Cj}$ (j=1, 2,...) zugeordnet, der durch das vom Sourceanschluß des Ausgangstransistors TW des betreffenden Redundanzdekoders $SRD_j$ geliefert wird und der mit seinem Drainanschluß am ersten Versorgungspotential $V_{cc}$ liegt. Die Sourceanschlüsse dieser Transistoren $T_{Cj}$ bilden wiederum einen gemeinsamen Knoten, der einerseits über die Source-Drainstrecke des bereits genannten MOS-FET's T2 mit dem Drain des durch das UND-Gatter U gesteuerten MOS-FET's T1 verbunden ist und andererseits über die Source-Drainstrecke eines weiteren MOS-FET's T6 an das Bezugspotential $V_{ss}$ anschaltbar ist. Hierzu wird das Gate dieses Verbindungstransistors T6 durch diejenige Taktfolge $\emptyset_{PC}$ gesteuert, die auch für die Steuerung des die Verbindung der für die Programmierung des betreffenden Redundanzdekoders $SRD_j$ vorgesehenen, auftrennbaren Verbindungsstellen F zum ersten Versorgungspotential $V_{cc}$ bildenden MOS-Transistors TS zuständig ist. Dagegen ist für die Steuerung dieses weiteren Transistors T2 dessen Gate mit einer Taktfolge $\emptyset_{EC}$ beaufschlagt, die auch in den einzelnen Spalten-Redundanzdekodern $SRD_j$ am Drain des Transistors TW liegt.

Zur Steuerung des Tristate-Ausgangs T7, T8 des Roll-Call-Dekoders gemäß Figur 3 sind nun die Drainanschlüsse der beiden Transistoren T1 und T2 gemeinsam über die Source-Drainstrecke eines Transfertransistors T3 an das Gate des am ersten Versorgungspotential $V_{cc}$ liegenden Transistors T7 des Tristate-Ausgangs T7, T8 angeschlossen. Außerdem ist zur Steuerung des am Bezugspotential $V_{ss}$ liegenden Transistors T8 des Tristate-Ausgangs ein weiterer Transfertransistor T4 vorgesehen, der den Drainanschluß der beiden Transistoren T1 und T2 an das Gate des am Bezugspotential $V_{ss}$ liegenden Transistor schaltet. Dabei ist in dem gezeichneten Beispielsfall die Verbindung zwischen den Drains der beiden Transistoren T1, T2 zum Transfertransistor T4 über einen Inverter i gegeben. Dieser Inverter könnte jedoch auch in Alternative zu der in Figur 3 dargestellten Möglichkeit auf dem Weg zwischen den Transistoren T1 und T2 zum Transistor T7 des Tristate-Ausgangs T7, T8 vorgesehen sein. Beide Transfertransistoren T3 und T4 werden gemeinsam durch den bereits für die Beaufschlagung des UND-Gatters U vorgesehenen Takt $\emptyset_{RC}$ gesteuert. Eine Realisierung des UND-Gatters kann z.B. mittels eines selbstsperrenden MOS-FET geschehen, dessen Source und dessen Gate als je ein Signaleingang und dessen Drain als der Signalausgang des UND-Gatters U betrieben werden.

Durch die erfindungsgemäße Dekoderschaltung gemäß Fig. 3 und die zugehörigen Steuerimpulse gemäß Fig. 4 bzw. Fig. 5 ist es nun möglich, die Adressen sowohl von defekten Wortleitungen als auch von defekten Bitleitungen eines RAM-Speichers mit dynamischer Peripherie und mit Adreßmultiplexing durch einen logischen Pegel am Ausgang DA der Tristate-Transistorkombination T7, T8 zu erkennen.

Das Zeitdiagramm gemäß Fig. 4 gibt den Zeitverlauf der zur Beaufschlagung des Dekoders gemäß Fig. 3 bei dem ausschließlich der Adressierung nach Wortleitungen dienenden Betrieb, dem sog. Only-RAS-Betrieb, erforderlichen Impulse $\overline{RAS}$, $\emptyset_{PR}$, $\emptyset_{RI}$ und $\emptyset_{RC}$ und das Zeitdiagramm gemäß Fig. 5 den Zeitverlauf der zur Beaufschlagung dieses Dekoders bei dem der Adressierung nach Bitleitungen dienenden Betrieb, dem sog. Early-Write-Betrieb, benötigten Impulse $\overline{RAS}$, $\overline{CAS}$, $\emptyset_{PR}$, $\emptyset_{RI}$, $\emptyset_{PC}$, $\emptyset_{EC}$, $\emptyset_{Cj}$ und $\emptyset_{RC}$ wieder. Diese Impulse sind in der aus Fig. 1 bzw. 3 bzw. 3a ersichtlichen Weise anzuwenden sind. Eine der Erzeugung dieser Impulse dienende Anlage wird noch anhand von Fig. 6 beschrieben.

Da die beiden Transistoren T7 und T8 auch jeweils durch je einen der beiden Datenausgänge Do bzw. $\overline{Do}$ des Ausgangstreibers OL gesteuert werden, empfiehlt es sich, den in in Figur 1 ersichtlichen Ausgang dieses Ausgangstreibers OL in der aus Fig. 3a ersichtlichen Weise an den aus den beiden Transistoren T7 und T8 gebildeten Tristate-Ausgang DA anzuschalten. Obwohl es im Prinzip möglich wäre, von einer Kombination des Datenausgangs mit dem Ausgang des Roll-Call-Dekoders abzusehen, empfiehlt sich eine solche Kombination aus verschiedenen Gründen. Einer der wichtigsten Gründe ist die Ersparnis an externen Anschlußelektroden, also Pins.

Zunächst ist im Hinblick auf Fig. 3a festzustellen, daß die vom Speicher SP gelieferte Dateninformation D und die hierzu invertierte Information $\overline{D}$ an den Ausgangsbuffer OL gelangt, der seinerseits durch vier verschiedene Sorten von Taktimpulsen, nämlich den Impulsen $\emptyset_o$, $\emptyset_D$, $\emptyset_C$ und $\overline{\emptyset}_C$, beaufschlagt ist. Hinsichtlich einer geeigneten Schaltung für den Ausgangstreiber OL kann wiederum auf die bereits genannte Patentanmeldung P 32 43 496.0 (=VPA 82 P 2022) (vgl. Fig. 5b) verwiesen werden, in der die Taktimpulse $\emptyset_C$, $\emptyset_o$ und $\overline{\emptyset}_C$ zur Steuerung des Ausgangstreibers OL eingesetzt und die Funktion dieser Impulse beschrieben ist. Der Takt $\emptyset_D$ ist bei solchen Schaltungen ebenfalls üblich, und hat die Aufgabe, ein Durchschalten der an den Datenausgängen D bzw. $\overline{D}$ anliegenden Daten an die Ausgänge Do bzw. $\overline{Do}$ des Buffers OL im Early-Write-Betrieb zu verbindern.

Die Datenausgänge Do bzw. $\overline{Do}$ des Ausgangstreibers OL liegen am Gate je eines der beiden den Tristate-Ausgang DA bildenden Transistoren T7 bzw. T8, wobei der mit seinem Drain am ersten Versorgungspotential $V_{cc}$ liegende Transistor durch den das normale Datensignal liefernden Ausgang Do und der mit seiner Source am Bezugspotential $V_{ss}$ liegende Transistor T8 durch den das invertierte Datensignal liefernden Ausgang $\overline{Do}$ des Ausgangsbuffers OL gesteuert ist. Schließlich sind noch zwei Entladungstransistoren T9 bzw. T10 vorgesehen, die zwischen dem Ausgang Do bzw. $\overline{Do}$ liegen und die durch ein gemeinsames Signal aktiviert werden. Dieses Steuersignal wird vom Ausgang eines UND-Gatters $U^*$ geliefert, dessen einer Eingang durch den Spalten-Adreßtakt $\overline{CAS}$ und dessen anderer Eingang unter Vermittlung eines Inverters $I^*$ von einem Taktimpuls $\emptyset_{RC}$ beaufschlagt ist, der, wie oben erwähnt, auch für den Taktbetrieb des Dekoders gemäß Fig. 3 benötigt wird.

In Zusammenhang mit Fig. 3a kann nun folgendes festgestellt werden: Die bei dynamischen RAM's übliche Ausgestaltung des Datenausgangs besteht aus dem als Ausgangsregister wirksamen Ausgangsbuffer OL, der die von der Speichermatrix SP stammenden Lesesignale D und $\overline{D}$ aufnimmt und verstärkt an die Gates der Transistoren T7 und T8 des Tristateausgangs weiterleitet. Eine von den Speicherbetriebstakten $\overline{CAS}$ (=Spalten-Adreßtakt) und $\overline{WE}$ (=Schreibeinleitungstakt) abgeleitete und durch die Takte $\emptyset_o$, $\emptyset_C$, $\overline{\emptyset}_C$ und $\emptyset_D$ gegebene Steuerung sorgt jedoch dafür, daß diese Weiterleitung bei den Betriebsarten Only-RAS (siehe Electronic Design 13, June 21, 1979, S. 58—61, insbes. S.61) und Early-Write ("Electronics, April 28/1977, S.115—119, insb. S.116") unterbleibt und der Datenausgang DA im Tristate-Zustand bleibt.

Erfindungsgemäß soll nun der Takt $\emptyset_{RC}$ nur dann den Wert logische "1" annehmen können, wenn der Roll-Call-Betrieb vorliegt, also m.a.W. der in Fig. 3 dargestellte und ebenfalls auf den Tristate-Ausgang T7 und T8 arbeitende Dekoder aktiviert wird. Dies kann ohne einen zusätzlichen Pin am Speicherbaustein z.B. dadurch erreicht werden, indem eine Freigabe des Taktes $\emptyset_{RC}$ nur dann auftritt, wenn ein Schmitttrigger (vgl. Fig. 6) am Dateneingangsanschluß einen vom Normalbetrieb abweichenden Eingangspegel registriert. Der Takt $\emptyset_{RC}$ kann außerdem dafür verwendet werden, um etwa vorhandene und vom Spalten-Adreßtakt $\overline{CAS}$ gesteuerte Datenausgangskiller T9 und T10 (vgl. Fig. 3a) außer Kraft zu setzen.

Die Funktionsweise des Dekoders gemäß Fig. 3 ist aufgrund der erfindungsgemäßen Schaltungsstruktur derart, daß bei Roll-Call im Only-RAS-Betrieb (also bei Anwendung der Impulse gemäß Figur 4) bei entsprechend angelegter Wortadresse eine logische "1" am Datenausgang DA erscheint, wenn die zu der betreffenden Wortadresse (auf das Zellenfeld N bezogen) gehörende Wortleitung des Zellenfelds N durch eine redundante Wortleitung aus dem Bereich RZ ersetzt worden ist.

Bei Roll-Call im Early-Write-Betrieb (d.h. also unter Verwendung der in Figur 5 dargestellten Taktimpulse, erscheint dann am Datenausgang DA des Tristates T7, T8 eine logische "1", wenn bei angelegter Bitadresse die zur Bitadresse gehörende Bitleitung des für den Normalbetrieb vorgesehenen Zellenfelds N durch eine redundante Bitleitung (also eine Bitleitung aus dem Bereich RS der Speichermatrix SP) ersetzt worden ist. Der Transfer des Roll-Call-Dekodiersignals auf den Datenausgang DA erfolgt über die Transfergates T3, T4, die durch den Takt $\emptyset_{RC}$ geöffnet werden.

Für das Auslesen der redundanten Bitleitungen muß gewährleistet sein, daß der Taktimpuls $\emptyset_{RC}$ zeitlich nach dem jeweils korrespondierenden Taktimpuls $\emptyset_{PC}$ kommt, um zu verhindern, daß eine logische "1" über den durch das UND-Gatter U gesteuerten Transfertransistor T1 an die für die Steuerung des Tristateausgangs maßgebende Stelle, also an den Drain des Transistors T1, gelangt. Für das Auslesen der redundanten Bitleitungen ist die jeweils anliegende Wortadresse bedeutungslos.

Die von den einzelnen Spaltenredundanzdekodern SRD$_j$ gelieferten Impulse $\emptyset_{Cj}$ gehen nur dann auf den Wert logisch "1", wenn über die einzelnen Bit-Redundanzdekoder (=Spaltenredundanzdekoder SRD) eine redundante Bitleitung angesprochen wird. Dieses Verhalten wird aus Fig. 1 unmittelbar verständlich, dasselbe gilt auch für die Impulse $\emptyset_{Ri}$, die von den Zeilen-Redundanzdekodern an den Roll-Call-Dekoder gem. Fig. 3 geliefert werden. Auch hier muß eine redundante Wortleitung über einen Zeilen-Redundanzdekoder angesprochen sein, damit der zugehörige Impuls $\emptyset_{Ri}$, d.h. also eine logische "1", an den Roll-Call-Dekoder abgegeben wird.

In Abweichung zu der aus Fig. 3 und 3a ersichtlichen Ausgestaltung kann sowohl der Roll-Call-Dekoder als auch der Speicherdatenausgang jeweils einen aus zwei Transistoren entsprechend Fig. 3 bzw. 3a T7 und T8 gebildeten Tri-State-Ausgang haben, wobei dann die beiden Tristate-Ausgänge, die dem Ausgang DA entsprechen, auf einen gemeinsamen Ausgangspin geschaltet sind. Schließlich kann auch, wie bereits oben bemerkt, jedem der beiden Tristate-Ausgänge je ein Ausgangspin zugeordnet sein. Sowohl bei dem anhand der Fig. 3 bzw. 3a beschriebenen Fall als auch bei Verwendung eines einzigen Pins für zwei Tristate-Ausgänge (von denen der eine zum Roll-Call-Dekoder und der andere zum Ausgangstreiber OL gehört) muß verhindert werden, daß das aus der Speichermatrix SP stammende Datensignal beim Betrieb im Roll-Call-Modus Einfluß auf den logischen Pegel am gemeinsamen Ausgangspin nehmen kann. Bei der anhand von Fig. 3 und 3a dargestellten Ausgestaltung ist dies durch die Taktführung erreicht. Ein evtl. vorgesehener Ladungskiller (T9, T10 gemäß Fig. 3a) muß dann durch den Takt $\emptyset_{RC}$ ausgeschaltet werden.

Die Taktimpulse $\emptyset_{PR}$ und $\emptyset_{RI}$ sind vom Zeilen-Adreßtakt $\overline{RAS}$, die Taktimpulse $\emptyset_{PC}$, $\emptyset_{EC}$ und $\emptyset_{Cj}$ sind vom Spalten-Adreßtakt $\overline{CAS}$ abhängig, die dann im Early-CAS durch einen $\overline{RAS}$-Impuls freigegeben werden.

Bei der in Fig. 6 dargestellten Impulswandlungsanlage hat man einen durch den Zeilen-Adreßtakt $\overline{RAS}$ gesteuerten Eingang, der über einen Verstärker V1 den zur Steuerung des Transistors T5 (Fig. 3) bzw. TS (Fig. 1) erforderlichen erforderlichen Impuls $\emptyset_{PR}$ liefert. Außerdem steuert der $\overline{RAS}$-Impuls einen Inverter I1, dessen Ausgang unmittelbar an den einen Eingang und über ein erstes Verzögerungsglied VG1 an den anderen Ausgang eines ersten UND-Gatters U1 gelegt ist. Außerdem steuert der Ausgang des ersten Inverters I1 den einen Eingang zweier weiterer UND-Gatter U2 und U3.

Der Ausgang des UND-Gatters U1 liefert die Impulse $\emptyset_{ER}$, die ihrerseits an den Drain des Ausgangstransistors TW in den vorgesehenen Zeilen-Redundanzdekodern ZRD$_i$ gelegt sind und die zu dem anhand von Fig. 1 beschriebenen Verhalten dieser Dekoder führen. Der Impuls $\emptyset_{ER}$ wird außerdem an den Eingang eines zweiten Verzögerungsgliedes VG2 gegeben, dessen Ausgang zur Steuerung des oben erwähnten zweiten UND-Gatters U2 zusammen mit dem Ausgang des ersten Inverters I1 vorgesehen ist. Der Ausgang des zweiten UND-Gatters U2 liegt über die Serienschaltung zweier weiterer Verzögerungsglieder VG3 und VG4 an dem einen Eingang des dritten UND-Gatters U3, dessen anderer Eingang, wie bereits erwähnt, vom Ausgang des ersten Inverters I1 beaufschlagt ist. Das dritte UND-Gatter U3 hat außerdem noch einen dritten Steuereingang, der von einem Dateneingangssignal DI unter Vermittlung eines Schmitt-Triggers ST gesteuert ist, und dessen Ausgang die Taktimpulse $\emptyset_{RC}$ liefert. Die Impulse $\emptyset_{RC}$ werden, wie bereits festgestellt wurde, zur Steuerung des UND-Gatters U sowie der beiden Transfertransistoren T3 und T4 bei dem erfindungsgemäßen Roll-Call-Dekoder gemäß Fig. 3 benötigt.

Wie aus Fig. 6 ersichtlich, liegt der Spaltenadreßtakt $\overline{CAS}$ ebenfalls am Eingang eines Verstärkers, nämlich des Verstärkers V2, an dessen Ausgang die zur Steuerung des Ausgangsbuffers OL

benötigten Taktimpulse $\overline{\emptyset}_C$ abnehmbar sind. Die zu diesen Impulsen $\overline{\emptyset}_C$ invertierten Taktimpulse $\overline{\emptyset}_C$, die ebenfalls zur Steuerung des Ausgangsbuffers OL benötigt werden, werden vom Ausgang eines eingangsseitig von den Spaltenadreßtakten $\overline{CAS}$ gesteuerten Inverters I2 geliefert.

Dieser zweite Inverter I2 des Impulsformers gemäß Fig. 6 steuert außerdem den einen Eingang eines weiteren UND-Gatters U5, dessen anderer Eingang vom Ausgang des bereits erwähnten zweiten UND-Gatters U2 des Impulsformers beaufschlagt ist. Der Ausgang dieses fünften UND-Gatters U5 liefert über einen weiteren Inverter I4 die Impulse $\emptyset_{PC}$, die zur Steuerung des Gates des Transistors TS in den einzelnen Spalten-Redundanzdekodern SRD$_j$, zur Steuerung des UND-Gatters U im Dekoder gemäß Fig. 3 und des Transistors T6 in diesem Dekoder vorgesehen sind. Der Ausgang des fünften UND-Gatters U5 steuert über ein fünftes Verzögerungsglied VG5 den einen Eingang eines sechsten UND-Gatters U6, dessen anderer Eingang mit den vom Ausgang des fünften UND-Gatters U5 gelieferten Impulsen beaufschlagt ist. Der Ausgang des sechsten UND-Gatters U6 liefert die Taktimpulse $\emptyset_{EC}$, die zur Beaufschlagung des Drains der Ausgangstransistoren TW in den einzelnen Spalten-Redundanzdekodern SRD$_j$ benötigt werden. Schließlich liegt der Ausgang des sechsten UND-Gatters U6 am Eingang eines sechsten Verzögerungsgliedes VG6. Der Ausgang dieses sechsten Verzögerungsglieds VG6 steuert zusammen mit dem Ausgang des fünften UND-Gatters U5 ein siebentes UND-Gatter U7, dessen Ausgang die Impulse $\emptyset_0$ liefert, die zur Taktsteuerung des Ausgangsbuffers OL gemäß Fig. 3a gebraucht werden.

Die bereits genannten und üblichen Schreibsignale $\overline{WE}$ steuern über einen dritten Inverter I3 zusammen mit dem Ausgang des fünften UND-Gatters U5 ein achtes UND-Gatter U8, welche die für die Steuerung des Ausgangsbuffers OL benötigten Impulse $\emptyset_D$ liefert.

Dabei ist noch folgendes festzustellen:

1.) Die Verzögerungsglieder sind einander gleich und sind z.B. durch die Reihenschaltung zweier Inverter gegeben. Diese Inverter sind im Aufbau und in der Bemessung—insbesondere bezüglich der Laufzeit—gleich den übrigen Invertern im Impulsformer.

2.) Aber auch die Verstärker werden bezüglich ihrer Laufzeit so eingestellt, daß diese Laufzeit mit der Laufzeit in den einzelnen Invertern übereinstimmt. Ein Beispiel, dies zu erreichen, ist in der Patentanmeldung P 32 43 496.0 (=VPA 82 P 2022) beschrieben.

3.) Die zur Steuerung des Schmitt-Triggers ST vorgesehenen Impulse DI sind mit den die zu speichernde Information bildenden und am Dateneingang des Speichers zu legenden Signalen identisch. Dies bedeutet, daß der Eingang des Schmitt-Triggers ST mit dem Dateneingang des Speichers verbunden ist.

Die in Figur 3 dargestellte Ausgestaltung für den den Kern der Erfindung bildenden Roll-Call-Dekoder kann in der aus Figur 7 ersichtlichen Weise, die sich insbesondere auf die Ausgestaltung in MOS-Technik spezialisiert, etwas abgeändert werden, ohne daß dabei die von der Erfindung angestrebte Wirkung nachteilig beeinflußt werden kann. Dabei ist hinsichtlich der Beschreibung von Fig. 7 festzustellen, daß die mit der Ausgestaltung gemäß Fig. 3 übereinstimmenden Teile mit demselben Bezugszeichen, wie in Fig. 3, bezeichnet sind. Es ist auch verständlich, daß der in Fig. 7 dargestellte Roll-Call-Dekoder in derselben Weise, wie der Dekoder nach Fig. 3, mit den Datenausgängen Do und $\overline{Do}$ zusammengeschaltet wird.

Zum Unterschied gegenüber der Ausgestaltung gemäß Fig. 3 ist im Falle der Ausgestaltung gemäß Fig. 7 der durch die Sourceanschlüsse der von den Zeilen-Redundanzdekodern ZRD$_i$ gesteuerten MOS-FET's TR$_i$, dem Drain des Transistors T5 und dem Eingang des Transistors T1 gebildete Knoten mit dem Drain eines weiteren Transistors T12 und dem Gate eines weiteren Transistors T13 verbunden. Beide Transistoren T12 und T13 liegen mit ihrem Sourceanschluß am Bezugspotential $V_{ss}$. Außerdem liegt das Gate des Transistors T12 und der Drain des Transistors T13 über die Source-Drainstrekke eines weiteren MOS-FET's T11 am ersten Versorgungspotential $V_{cc}$, mit dem auch das Gate des zuletzt genannten Transistors T11 verbunden ist.

In entsprechender Weise ist der durch die Sourceanschlüsse der von den vorgesehenen Spalten-Redundanzdekodern SRD$_j$ beaufschlagten Transistoren T$_{cj}$ und den Drainanschluß des Transistors T6 gebildete Knoten mit dem Drain eines Transistors T17 bzw. mit dem Gate eines weiteren MOS-FET's T18 verbunden, deren Sourceanschluß ebenfalls am Bezugspotential $V_{ss}$ liegt. Der Drain des Transistors T18 und das Gate des Transistors T18 sind ebenfalls über einen Transistor T16 an das erste Versorgungspotential $V_{cc}$ gelegt, mit dem auch das Gate des Transistors T16 verbunden ist.

Aufgrund der beschriebenen Ergänzungen der beiden Eingangsteile des Roll-Call-Dekoders ist der Sourceanschluß des Transistors T1 unmittelbar mit dem Drain von T12 und dem Gate von T13 verbunden, während die Source des Transistors T2 am Drain vin T17 und am Gate von T18 liegt.

Das Gate des Transistors T1 sowie das Gate des Transistors T2 erfährt zusätzlich zu der aus Fig. 3 ersichtlichen Ansteuerung jeweils noch eine weitere Ansteuerung. Das durch den MOS-Feldeffekttransistor T14 realisierte UND-Gatter U liegt mit seinem Ausgang (dem Drain von T14) am Gate von T1, und außerdem über einen vom Takt $\emptyset_{EC}$ gesteuerten Transistor T15 am Bezugspotential sowie an einem Kondensator C1, der durch ein (bei einer Schaltung gemäß Fig. 3 nichtvorgesehenes Taktsignal $\emptyset_{RC2}$ beaufschlagt ist und eine zusätzliche Steuerung des Gates von T1 bildet. Derselbe Takt $\emptyset_{RC2}$ liegt über einen Kondensator C2 am Gate des Transistors T2. Außerdem erfolgt die Beaufschlagung des Gates von T2 unter Vermittlung eines Transistors T19, dessen Gate am

ersten Versorgungspotential $V_{cc}$ liegt und dessen Drain mit dem Gate des zu steuernden Transistors T2 verbunden ist, während sein Sourceanschluß mit den zur Steuerung von T2 in übereinstimmung mit Fig. 3 vorgesehenen Taktsignalen $\emptyset_{EC}$ beaufschlagt ist.

Weitere Abweichungen im Vergleich zu Fig. 3 sind bezüglich der Ansteuerung der beiden Tristate-Ausgangstransistoren T7 und T8 durch den vom Drain der beiden Transistoren T1 und T2 gebildeten Schaltungsknoten A festzustellen. So wird zur Steuerung des Transfertransistors T3 und des Transfertransistors T4 nicht der Impuls $\emptyset_{RC}$ sondern der Impuls $\emptyset_{RC2}$ verwendet, der mittels einer aus Fig. 7a ersichtlichen Ergänzung des Impulsformers gemäß Fig. 6 aus dem Zeilen-Adreßtakt $\overline{RAS}$ und dem Takt $\emptyset_{RC}$ abgeleitet werden kann. Aber auch der in Fig. 3 vorgesehene Inverter I wird bei der Ausgestaltung gemäß Fig. 7 durch ein kompliziertes Schaltungsgebilde ersetzt.

Bei diesem Schaltungsgebildet ist ein Kondensator C3 vorgesehen, der durch den Impuls $\emptyset_{RC2}$ beaufschlagt ist, und der diesen an einen Knoten weiterleitet, der durch drei weitere MOS-Feldeffekttransistoren T21 und T22 sowie T23 bedingt ist. Bei dieser Transistorkonfiguration liegt der Transistor T21 mit seinem Drain am ersten Versorgungspotential $V_{cc}$ und mit seinem Sourceanschluß an dem besagten Knoten. Der Transistor T22 liegt mit seinem Drain an dem besagten Knoten und mit seiner Source am Bezugspotential $V_{ss}$. Das zur Steuerung des Gates des Transistors T22 dienende Potential wird vom Knoten A, also dem Drain von T1 und T2, geliefert, der außerdem über die Source-Drainstrecke eines durch den Takt $\emptyset_{PR}$ gesteuerten Entladetransistor T20 mit dem Bezugspotential $V_{ss}$ verbunden ist. Das Gate des dritten an der Bildung des besagten Knotens beteiligten Transistors, also des Transistors T23, ist unmittelbar mit dem besagten Knoten, verbunden, während der Drain dieses Transistors T23 am Versorgungspotential $V_{cc}$ und mit seinem Sourceanschluß einerseits am Sourceanschluß des zum Transistor T8 des Tristate-Ausgangs leitenden Transfertransistors T4 liegt und anderseits über die Source-Drainstrecke eines weiteren MOS-Feldeffekttransistors T24, dessen Gate unmittelbar mit dem Knoten A, also dem Drain von T1 und T2, verbunden ist, an das Bezugspotential $V_{ss}$ gelegt ist. Wie bereits bemerkt, ist das Steuersignal für den Transfertransistor T4—ebenso wie beim Transfertransistor T3—nicht wie bei Fig. 3 durch $\emptyset_{RC}$ sondern durch $\emptyset_{RC2}$ gegeben.

Zur Ableitung des Taktsignals $\emptyset_{RC2}$ aus den Takten $\emptyset_{RC}$ und $\overline{RAS}$ ist ein UND-Gatter U9 vorgesehen (vgl. Fig. 7a), dessen Ausgang die Impulse $\emptyset_{RC2}$ liefert und dessen einer Eingang unter Vermittlung eines Inverters I5 durch den Zeilenadreßtakt $\overline{RAS}$ und dessen anderer Eingang unter Vermittlung eines Verzögerungsgliedes VG7 durch den Takt $\emptyset_{RC}$ gesteuert ist. Die in Fig. 7a dargestellte Ergänzung des Impulsformers gemäß Fig. 6 ist nach den dort angegebenen Richtlinien für die Bemessung von VG7 und I5 konstruiert.

Die in Fig. 7 dargestellte Ausgestaltung des Roll-Call-Dekoders gemäß der Erfindung hat folgende Vorteile:

Die RS-Flip-Flops T11, T12, T13 bzw. T16, T17, T18 sorgen dadür, daß die Signale an den Dekoderknoten trotz eventueller Störeinflüsse auch dann ein definiertes Potential behalten, wenn sowohl die Transistoren $T_{Ri}$ und T5 bzw. $T_{Cj}$ und T6 gesperrt sind.

Die Transistoren T14 und T15 bilden das UND-Gatter U.

Die Transistoren T21, T22, T23, T24 bilden mit dem Kondensator C3 den Inverter I, wobei mittels des Kondensators C3 ein Bootstrap am Gate von T23 erfolgt, um am Eingang des Transfertransistors T4 im Falle der logischen "1" die volle Betriebsspannung $V_{cc}$ zu erreichen.

Der Transistor T20 sorgt für ein definiertes Bezugspotential am Knoten A, fall weder T1 noch T2 öffnen.

C1, T14 bzw. C2 und T19 ermöglichen einen Bootstrap am Gate von T1 bzw. T2, um die volle Spannung der Dekoderknoten an den Punkt A der Schaltung zu bringen. Insbesondere im Falle von C1, T14 ist dabei ein gegenüber dem Takt $\emptyset_{RC}$ verzögerter Takt $\emptyset_{RC2}$ von Vorteil.

## Patentansprüche

1. Integrierter dynamischer Schreib-Lesespeicher, bei dem die aus einander gleichen Speicherzellen bestehende Speichermatrix über wenigstens einen Zeilendekoder und einen Spaltendekoder hinsichtlich der einzelnen Speicherzellen adressierbar ist, wobei die Adressierung nach den Matrixspalten jeweils durch einen Spalten-Adreßtakt $\overline{CAS}$ und die Adressierung nach den Matrixzeilen jeweils durch einen Zeilenadreßtakt $\overline{RAS}$ eingeleitet wird, bei dem außerdem die Speichermatrix wenigstens eine redundante Zeile und/oder Spalte aufweist, die zunächst vom Normalbetrieb des Speichers ausgeschlossen und erst aufgrund einer besonderen Maßnahme für den Normalbetrieb—und zwar als Ersatz—verfügbar ist, dadurch gekennzeichnet, daß der aufgrund der jeweiligen Adressierung mit den eingespeicherten digitalen Daten (Do, $\overline{Do}$) beaufschlagte und als Tristate-Treiber (T7, T8) ausgestaltete Datenausgang (DA) des Speichers durch den Ausgang eines weiteren und als Dekoder ausgestalteten Schaltungsteils (Roll-Call-Dekoder) beeinflußt wird und daß dieser Schaltungsteil derart ausgestaltet und gesteuert ist, daß bei der Adressierung jeder durch eine redundante Zeile bzw. Spalte ersetzten Zeile bzw. Spalte des ursprünglich für den Normalbetrieb vorgesehenen Teils (N) der Speichermatrix (SP) und bei gleichzeitiger externer Aktivierung des als Dekoder ausgebildeten weiteren Schaltungsteils dieser eine Sperrung des normalen Datenwegs (Do, $\overline{Do}$) von der Speichermatrix (SP) zum Tristate-Ausgang (DA) und das Erscheinen eines den Einsatz einer redundanten Zeile bzw. Spalte anstelle der adressierten und dem für den Normalbetrieb vorgesehenen Teil (N) der Speichermatrix (SP) anzeigenden einheitlichen Anzeigesignals an einem Signalausgang, insbesondere am Datenausgang (DA) des Speichers bewirkt.

2. Vorrichtung nach Anspruch 1, dadurch gekennzeichnet, daß zum Auslesen der Adressen defekter Zeilen eine lediglich vom Zeilenadreßtakt $\overline{(RAS)}$ abhängige Taktung des als Dekoder ausgebildeten und unmittelbar auf den Tristateausgang arbeitenden Schaltungsteils (Only-RAS-Zyklen) und zum Auslesen defekter Spalten eine Betätigung des Zeilenadreßtakts $\overline{(RAS)}$ sowie eine Betätigung des Spaltenadreßtakts $\overline{(CAS)}$ Verwendung findet, wobei der Schreibimpuls $\overline{(WE)}$ vor oder gleichzeitig mit dem Spaltenadreßtakt $\overline{(CAS)}$ eintrifft oder die Verzögerung zwischen den beiden korrespondierenden Impulsen der beiden Sorten $\overline{(CAS, WE)}$ so klein eingestellt ist, daß eine Sperrung des normalen Datenwegs von der Speichermatrix zum Datenausgang (DA) gewährleistet ist (Early-Write-Zyklen).

3. Vorrichtung nach Anspruch 1 oder 2, dadurch gekennzeichnet, daß jeder der redundanten Matrixzeilen (RZ) und jeder der redundanten Matrixspalten (RS) je ein Redundanzdekoder (ZDR bzw, SDR) zugeordnet und dieser so ausgebildet ist, daß aufgrund einer bleibenden Einstellung dieses Redundanzdekoders dieser auf ein einer defekten Matrixzeile bzw. defekten Matrixspalte des für den Normalbetrieb vorgesehenen Teils (N) der Speichermatrix (SP) zugeordnetes Adressiersignal reagiert und stattdessen eine redundante Zeile bzw. Spalte aktiviert und außerdem ein zur Steuerung des den Signalausgang (DA) bildenden Tristatetreibers (T7, T8) dienendes Signal so abgibt, daß dieses Signal nur beim Vorliegen des extern auszulösenden aktivierten Zustandes eines aus MOS-Feldeffekttransistoren gebildeten Eingangs über den als Dekoder ausgestalteten Schaltungsteil auf den als Tristatetreiber (T7, T8) arbeitenden Datenausgang (DA) gelangt.

4. Vorrichtung nach Anspruch 3, dadurch gekennzeichnet, daß jedem Redundanzdekoder (RZD$_i$, RSD$_j$) je ein durch den Ausgang desselben an seinem Gate gesteuerter und mit seinem Drainanschluß am ersten Versorgungspotential (V$_{cc}$) liegender MOS-Feldeffekttransistor (T$_{RI}$, T$_{Cj}$) fest zugeordnet ist, daß dabei der Drainanschluß dieser Feldeffekttransistoren über einen getakteten MOS-Feldeffekttransistor (T5 bzw. T6) mit dem Bezugspotential (V$_{ss}$) verbunden ist und außerdem über getaktete Transfertransistoren (T3, T4 zur Steuerung des Tristateausgangs (T7, T8) verwendet ist.

5. Vorrichtung nach Anspruch 4, dadurch gekennzeichnet, daß der dem einzelnen Zeilen-Redundanzdekoder (ZRD$_i$) jeweils zugeordnete MOS-Feldeffekttransistor (T$_{RI}$) mit seinem Sourceanschluß mit dem Sourceanschluß des den übrigen Zeilen-Redundanzdekodern (ZRD$_i$) jeweils zugeordneten MOS-Feldeffekttransistors (T$_{RI}$) unmittelbar verbunden ist und für die Verbindung der Sourceanschlüsse dieser Transistoren zum Bezugspotential (V$_{ss}$) ein gemeinsamer und

durch ein erstes Taktsignal (Ø$_{PR}$) gesteuerter MOS-Feldeffekttransistor (T5) im Eingangsteil der als Dekoder ausgestalteten und auf den Tristateausgang arbeitenden Schaltung vorgesehen ist, daß außerdem der den einzelnen Spalten-Redundanzdekodern (RSD$_j$) jeweils zugeordnete Feldeffekttransistor (T$_{Cj}$) an seinem Sourceanschluß mit dem Sourceanschluß des den übrigen Spalten-Redundanzdekodern (SRD$_j$) jeweils zugeordneten MOS-Feldeffekttransistors (T$_{cj}$) unmittelbar verbunden und für die Verbindung dieser Sourceanschlüsse zum Bezugspotential (V$_{ss}$) ebenfalls ein gemeinsamer und durch ein zweites Taktsignal (Ø$_{PC}$) gesteuerter MOS-Feldeffekttransistor (T6) vorgesehen ist, daß dabei die Sourceanschlüsse der durch die Zeilen-Redundanzdekoder (ZRD$_i$) gesteuerten MOS-Feldeffekttransistoren (T$_{RI}$) gemeinsam an den Sourceanschluß eines unter Vermittlung eines—seinerseits durch das zweite Taktsignal (Ø$_{PC}$) als auch durch ein drittes Taktsignal (Ø$_{RC}$) beaufschlagten UND-Gatters (U) gesteuerten—ersten Transfertransistors (T1) sowie die Sourceanschlüsse der durch die Spalten-Redundanzdekoder (SRD$_j$) gesteuerten MOS-Feldeffekttransistoren (T$_{cj}$) im Eingangsteil des als Dekoder ausgebildeten Schaltungsteils an den Sourceanschluß eines zweiten und durch ein viertes Taktsignal (Ø$_{EC}$) gesteuerten Transfertransistors (T2) gelegt sind, daß weiterhin die miteinander verbundenen Drainanschlüsse der beiden Transfertransistoren (T1, T2 T2) einerseits unter Vermittlung eines dritten und durch das dritte Taktsignal (Ø$_{RC}$) gesteuerten Transfertransistors, T3) an das—insbesondere auch durch das vom Speicher stammende Datensignal (Do, $\overline{Do}$) gesteuerte Gate des am ersten Versorgungspotential (V$_{cc}$) liegenden Ausgangstransistors (T7) geschaltet sind, während sie andererseits über die Serienschaltung eines Inverters (I) und eines vierten—ebenfalls vom dritten Taktsignal (Ø$_{RC}$) gesteuerten Transfertransistors (T4) an das—insbesondere auch von dem aus dem Speicher stammenden invertierten Datensignal (Do) gesteuerte—Gate des am Bezugspotential (V$_{ss}$) liegenden MOS-Feldeffekttransistors (T8) der beiden den Tristateausgang bildenden Transistoren (T7, T8) gelegt ist.

6. Vorrichtung nach einem der Ansprüche 1 bis 5, dadurch gekennzeichnet, daß die von der Speichermatrix (SP) an deren Datenausgängen (D, $\overline{D}$) anfallenden Informationsdaten über einen taktgesteuerten Ausgangstreiber (OL) an den Tristateausgang (T7, T8) gelangen, daß hierzu der dem direkten Signal entsprechende Datenausgang (Do) des Ausgangstreibers (OL) mit dem Gate des am ersten Vorsorgungspotential (V$_{cc}$) liegenden MOS-Feldeffekttransistors (T7) des Tristateausgangs und außerdem über die Source-Drainstrecke eines ersten Entladetransistors (T9) mit dem Bezugspotential (V$_{ss}$) verbunden ist, daß außerdem der dem invertierten Datensignal entsprechende Datenausgang $\overline{(Do)}$ des Ausgangstreibers (OL) mit dem Gate des am Bezugspotential (V$_{ss}$) liegenden Transistors (T8) des Tristateausgangs (T7, T8) verbunden ist und außer-

11

dem über einen weiteren Entladetransistor (T10) mit dem Bezugspotential (V$_{ss}$) verbunden ist und daß schließlich die beiden Entladetransistoren (T9, T10) gemeinsam durch den Ausgang eines UND-Gatters (U$^*$) gesteuert sind, dessen einer Eingang vom Spaltenadreßtakt $\overline{(CAS)}$ und dessen zweiter Eingang—unter Vermittlung eines Inverters (I$^*$) von dem sowohl das UND-Gatter (U) als auch den dritten Transfertransistor (T3) sowie den vierten Transfertransistor (T4) schaltenden Taktimpuls (Ø$_{RC}$) gesteuert sind.

7. Vorrichtung nach einem der Ansprüche 4 bis 6, dadurch gekennzeichnet, daß zur Erzeugung der zur Steuerung des UND-Gatters (U) sowie des dritten und vierten Transfertransistors (T3, T4) erforderlichen Taktimpulse (Ø$_{RC}$) der Zeilenadreßtakt $\overline{(RAS)}$ an den Eingang eines ersten Inverters (I1) gelegt und der Ausgang dieses ersten Inverters (I1) zur Steuerung eines ersten UND-Gatters (U1) derart vorgesehen ist, daß der eine-Eingang dieses UND-Gatters (U1) unmittelbar durch den Inverter (I1) und der andere Eingang des UND-Gatters durch den Inverter (I1) über ein erstes Verzögerungsglied (VG1) beaufschlagt ist, daß ferner der Ausgang dieses ersten UND-Gatters (U1) zur Beaufschlagung eines zweiten Verzögerungsglieds (VG2) und dessen Ausgang zur Steuerung eines zweiten UND-Gatters (U2) dient, dessen anderer Eingang unmittelbar durch den Ausgang des ersten Inverters (I1) beaufschlagt ist, und daß schließlich der Ausgang des zweiten UND-Gatters (U2) unter Verwendung zweier hintereinander geschalteter weiterer Verzögerungsglieder (VG3, VG4) an den einen Eingang des die gewünschten Taktimpulse (Ø$_{RC}$) für das UND-Gatter (U) und das Gate des dritten bzw. vierten Transfertransistors (T3, T4) liefernden Ausgangs-UND-Gatters (U3) des Taktformers gelegt ist, dessen anderer Eingang unmittelbar durch den Ausgang des ersten Inverters (I1) gesteuert ist, während sein letzter Eingang am Ausgang eines Schmitt-Triggers (ST) liegt, der seinerseits durch ein vom normalen Eingangspegel abweichendes Eingangssignal (Di) aktivierbar ist.

8. Vorrichtung nach Anspruch 7, dadurch gekennzeichnet, daß zur Steuerung des im Eingangteil des Dekoders vorgesehenen und die Verbindung der von den Spalten-Redundanzdekodern gesteuerten Transistoren (T$_{Cj}$) zum Bezugspotential (V$_{ss}$) bildenden MOS-Feldeffekttransistors (T6) Taktimpulse (Ø$_{PC}$) verwendet sind, die ihrerseits vom Ausgang eines Inverters (I4) geliefert werden, der vom Ausgang eines UND-Gatters ((U5) gesteuert wird, dessen einer Eingang vom Ausgang des zweiten UND-Gatters (U2) in dem vom Zeilenadreßtakt $\overline{(RAS)}$ gesteuerten Teil des Impulsformers und dessen zweiter Eingang durch den Ausgang eines weiteren Inverters (I2) gesteuert ist, dessen Eingang von den Spalten-Adreßtakten $\overline{(CAS)}$ beaufschlagt ist.

9. Vorrichtung nach Anspruch 8, dadurch gekennzeichnet, daß die von dem für die Steuerung des die Impulse (Ø$_{PC}$) liefernden Inverters (I4) zuständigen fünften UND-Gatters (U5) gelieferten Impulse zur Steuerung eines weiteren UND-Gatters (U6) vorgesehen sind, indem der eine Eingang dieses UND-Gatters (U6) unmittelbar an den Ausgang des steuernden UND-Gatters (U5) gelegt ist, während die Steuerung des zweiten Eingangs des weiteren UND-Gatters (U6) durch den Ausgang des steuernden UND-Gatters (U5) unter Vermittlung eines Verzögerungsgliedes (VG5) erfolgt, und daß am Ausgang des gesteuerten UND-Gatters (U6) die zur Beaufschlagung des Gates des zweiten Transfertransistors (T2) in dem auf den Tristateausgang (T7, T8) geschalteten Dekoder erforderlichen Impulse (Ø$_{EC}$) abnehmbar sind.

10. Vorrichtung nach einem der Ansprüche 7 bis 9, dadurch gekennzeichnet, daß der Impulsformer derart weiter ausgestaltet ist, daß er aufgrund der Beaufschlagung mit dem Zeilen-Adreß-Takt $\overline{(RAS)}$ und dem Spaltenadreßtakt $\overline{(CAS)}$ gleichzeitig auch die zur Steuerung des Datenausgangstreibers (OL) erforderlichen Taktimpulse (Ø$_D$, Ø$_o$, Ø$_C$, $\overline{Ø}_C$) liefert.

11. Vorrichtung nach einem der Ansprüche 7 bis 10, dadurch gekennzeichnet, daß die verwendeten Verzögerungsglieder auf gleiche Laufzeit eingestellt sind.

12. Vorrichtung nach Anspruch 4 oder 5, dadurch gekennzeichnet, daß der den ersten Transfertransistor (T1) und den zweiten Transfertransistor (T2) mit den Transistoren (T7, T8) des Tristateausgangs verbindende Schaltungsteil, sowie die Steuerung dieser beiden Transfertransistoren (T1, T2) auf deren Source- und Gateseite entsprechend Figur 7 ausgestaltet ist.

13. Vorrichtung nach einem der Ansprüche 5 bis 12, dadurch gekennzeichnet, daß das den ersten Transfertransistor (T1) steuernde UND-Gatter (U) durch einen MOS-Feldeffekttransistor (T14) gegeben ist.

**Revendications**

1. Mémoire d'enregistrement/lecture dynamique intégrée, dans laquelle la matrice de mémoire constituée par des cellules de mémoire identiques peut être adressée par l'intermédiaire d'au moins un décodeur de lignes et un décodeur de colonnes en rapport avec les différentes cellules de mémoire, et dans laquelle l'adressage suivant les colonnes de la matrice est déclenchée respectivement par une impulsion de cadence d'adresse de colonne $\overline{CAS}$ et l'adressage suivant les lignes de la matrice est déclenché respectivement par une impulsion de cadence d'adresse de ligne $\overline{RAS}$, et dans lequel en outre la matrice de mémoire comporte au moins une ligne et/ou une colonne redondante qui est tout d'abord exclue du fonctionnement normal de la mémoire et est disponible seulement sur la base d'une disposition particulière pour le fonctionnement normal -et ce à titre de remplacement-, caractérisée par le fait que la sortie de données (DA) de la mémoire, qui est chargée par les données numériques mémorisées (Do, $\overline{Do}$), sur la base de l'adressage respectif, et est agencée sous la forme d'un étage d'attaque trois-états (T7, T8), est influencée par la sortie d'un autre élément de circuit agencé sous la forme d'un décodeur (décodeur Roll-Call), et que cet élément de circuit est agencé et commandé de manière que, lors de l'adressage de chaque ligne ou colonne remplacée par une ligne ou une colonne redondante, de la partie (N), prévue initialement pour le fonctionnement normal, de la matrice de mémoire (SP) et lors d'une activation externe simultanée de l'autre élément de circuit agencé sous la forme d'un décodeur, ce dernier réalise un blocage de la voie normale de transmission de données (Do, $\overline{Do}$) depuis la matrice de mémoire (SP) vers la sortie trois-états (DA) et l'apparition d'un signal indicateur uniforme, indiquant l'utilisation d'une ligne et d'une colonne redondante à la place de la partie (N) de la matrice de mémoire (SP), adressée et prévue pour le fonctionnement normal, sur une sortie de signaux, notamment sur la sortie de données (DA) de la mémoire.

2. Dispositif suivant la revendication 1, caractérisé par le fait que pour la lecture des adresses de lignes défectueuses, on utilise un cadencement, qui dépend uniquement de l'impulsion de cadence d'adresse de ligne ($\overline{RAS}$), de l'élément de circuit réalisé sous la forme d'un décodeur et agissant directement sur la sortie trois-états (cycles Only-RAS) et, pour la lecture de colonnes défectueuses, on utilise une activation de l'impulsion de cadence d'adresse de ligne ($\overline{RAS}$) ainsi qu'une activation de l'impulsion d'adresse de colonne ($\overline{CAS}$), l'impulsion d'enregistrement (WE) apparaissant avant ou en même temps que l'impulsion de cadence d'adresse de colonne (CAS), ou bien le retard entre les deux impulsions correspondantes des deux types ($\overline{CAS}$, $\overline{WE}$) étant réglé à une valeur suffisamment faible pour garantir un blocage de la voie normale de transmission de données de la matrice de mémoire à la sortie de données (DA) (cycle Early-Write).

3. Dispositif suivant la revendication 1 ou 2, caractérisé par le fait qu'à chacune des lignes redondantes (RZ) de la matrice et à chacune des colonnes redondantes (RS) de la matrice est associé un décodeur respectif de redondance (ZDR ou SDR) et que ce décodeur de redondance est agencé de telle sorte que, sur la base de son réglage permanent, il réagit à un signal d'adresse associé à une ligne défectueuse ou une colonne défectueuse de la partie (N), prévue pour le fonctionnement normal, de la matrice de mémoire (SP) et, au lieu de cela, active une ligne ou une colonne redondante et en outre délivre un signal servant à commander l'étage d'attaque trois-états (T7, T8) constituant la sortie de signaux (DA), de telle sorte que ce signal parvient à la sortie de données (DA) fonctionnant en tant qu'étage d'attaque trois-états (T7, T8), uniquement lors de la présence de l'état activé, devant être redéclenché de l'extérieur, d'une entrée, formée de transistors à effet de champ MOS, par l'intermédiaire de l'élément de circuit agencé sous la forme d'un décodeur.

4. Dispositif suivant la revendication 3, caractérisé par le fait qu'à chaque décodeur de redondance (RZD$_i$, RSD$_j$) est associé de façon fixe respectivement un transistor à effet de champ MOS (T$_{Ri}$, T$_{Cj}$), qui est commandé au niveau de sa grille par la sortie du décodeur de redondance et dont la borne de drain est placée à un premier potentiel d'alimentation (V$_{cc}$), que la borne de drain de ces transistors à effet de champ et reliée par l'intermédiaire d'un transistor à effet de champ MOS (T5 ou T6) commandé de façon cadencée, am potentiel de référence (V$_{ss}$) et est en outre utilisé, par l'intermédiaire de transistors de transfert (T3, T4) commandés de façon cadencée, pour la commande de la sortie trois états (T7, T8).

5. Dispositif suivant la revendication 4, caractérisé par le fait que le transistor à effet de champ MOS (T$_{Ri}$) associé au décodeur respectif de redondance de ligne (ZRD$_i$) est relié directement, par sa borne de source, à la borne de source du transistor à effet de champ MOS (T$_{Ri}$) respectivement associé aux autres décodeurs de redondance de lignes (ZRD$_i$), et qui est prévu, pour la liaison des bornes de source de ces transistors avec le potentiel de référence (V$_{ss}$), un transistor à effet de champ MOS commun (T5), commandé par un premier signal de cadence (Ø$_{PR}$), situé dans la partie d'entrée du circuit agencé à la manière d'un décodeur et travaillant sur la sortie trois-états, qu'en outre le transistor à effet de champ (T$_{Cj}$), associé respectivement aux différents décodeurs de redondance de colonnes (RSD$_j$) est relié, par sa borne de source, à la borne de source du transistor à effet de champ MOS (T$_{Cj}$) respectivement associé aux autres décodeurs de redondance de colonnes (SRD$_j$) et qu'il est également prévu, pour la liaison de ces bornes de source au potentiel de référence (V$_{ss}$), un transistor à effet de champ MOS commun (T6), commandé par un second signal de cadence (Ø$_{PC}$), et que les bornes de source des transistors à effet de champ MOS (T$_{Ri}$), commandées par les décodeurs de redondance de lignes (ZRD$_i$), sont raccordées en commun à la borne de source d'un premier transistor de transfert (T1) -commandé par l'intermédiaire d'une porte ET (U) chargée pour sa part par le second signal de cadence (Ø$_{PC}$) ainsi que par un troisième signal de cadence (Ø$_{PC}$)-, et que les bornes de source des transistors à effet de champ MOS (T$_{Cj}$) commandées par le décodeur de redondance de colonnes (SRD$_j$) situées dans la partie d'entrée de l'élément de circuit réalisé sous la forme d'un décodeur sont raccordées à la borne de source d'un second transistor de transfert commandé par un quatrième signal de cadence (Ø$_{EC}$), en outre les bornes de drain, reliées entre elles, des deux transistors de transfert (T1, T2) sont raccordées d'une part par l'intermédiaire d'un troisième transistor de transfert (T3) commandé par le troisième signal de cadence (Ø$_{RC}$), à la grille -notamment commandée également par le signal de données (Do, $\overline{Do}$) provenant de la mémoire- du transistor de sortie (T7) raccordé au premier potentiel d'alimentation (V$_{cc}$), tandis qu'ils sont raccordés d'autre part, par l'intermédiaire du circuit série formé d'un inverseur (I) et d'un quatrième transistor de transfert (T4) -également commandé par le troisième signal de cadence ($Ø_{RC}$), à la porte -notamment commandée également par le signal de données inversé (Do) délivré par la mémoire- du transistor à effet de champ MOS T8, placé au potentiel de référence ($V_{ss}$), les deux transistors (T7, T8) constituant la sortie trois-états.

6. Dispositif suivant l'une des revendications 1 à 5, caractérisé par le fait que les données d'informations qui sont délivrées par la matrice de mémoire (SE) à ses données de sortie (D, D), parviennent, par l'intermédiaire d'un étage d'attaque de sortie (OL), commandé de façon cadencée, à la sortie trois-états (T7, T8), qu'à cet effet la sortie de données (Do), qui correspond au signal direct, de l'étage d'attaque de sortie (OL) est reliée à la porte du transistor à effet de champ MOS (T7), placé au premier potentiel d'alimentation ($V_{cc}$), de la sortie trois-états et en outre, par l'intermédiaire de la voie source-drain d'un premier transistor de décharge (T9), au potentiel de référence ($V_{ss}$), qu'en outre la sortie de données ($\overline{Do}$), qui correspond au signal de donnée inversé, de l'étage d'attaque de sortie (OL) est reliée à la grille du transistor (T8), placé au potentiel de référence ($V_{ss}$), de la sortie trois-états (T7, T8), et est en outre relié par l'intermédiaire d'un autre transistor de décharge (T10) au potentiel de référence ($V_{ss}$), et qu'enfin les deux transistors de décharge (T9, T10) sont commandés en commun par la sortie d'une porte ET ($U^*$), dont une entrée est commandée par l'impulsion de cadence d'adresse de colonne ($\overline{CAS}$) et dont la seconde entrée est commandée -par l'intermédiaire d'un inverseur ($I^*$)- par l'impulsion de cadence ($Ø_{RC}$), qui commande aussi bien la porte ET (U) que le troisième transistor de transfert (T3) et le quatrième transistor de transfert (T4).

7. Dispositif suivant l'une des revendications 4 à 6, caractérisé par le fait que pour la production des impulsions de cadence ($Ø_{RC}$) nécessaires pour la commande de la porte ET (U) ainsi que les troisième et quatrième transistors de transfert (T3, T4), l'impulsion de cadence d'adresse de ligne ($\overline{RAS}$) est appliquée à l'entrée d'un premier inverseur (I1) et la sortie de ce premier inverseur (I1) est prévue pour la commande d'une première porte ET (U1), de telle sorte qu'une entrée de cette porte (U1) est chargée directement par l'inverseur (I1) et que l'autre entrée de la porte ET est chargée par l'inverseur (I1) par l'intermédiaire d'un premier circuit de retardement (VG), qu'en outre la sortie de cette première porte ET (U1) est utilisée pour charger un second circuit de retardement (VG2) et que la sortie de ce dernier sert à commander une seconde porte ET (U2), et dont l'autre entrée est chargée directement par la sortie du premier inverseur (I1), et qu'enfin le signal de sortie de la seconde porte ET (U2) est raccordé, moyennant l'utilisation de deux autres circuits de retardement (VG3, VG4) branchés en série, à une entrée de la porte ET de sortie (U3), qui délivre les impulsions de cadence désirée ($Ø_{RC}$) pour la porte ET (U) et pour la porte des troisième et quatrième transistors de transfert (T3, T4), du dispositif de mise en forme d'impulsions de cadence, dont l'autre entrée est commandée directement par la sortie du premier inverseur (I1), tandis que sa dernière entrée est raccordée à la sortie d'un déclencheur de Schmitt (ST), qui peut être activé, pour sa part, par un signal d'entrée (Di) qui diffère du niveau d'entrée normal.

8. Dispositif suivant la revendication 7, caractérisé par le fait que pour la commande du transistor à effet de champ MOS (T6), qui est prévu dans la partie d'entrée du décodeur et établit la liaison entre les transistors ($T_{cj}$), commandés par les décodeurs de redondance de colonnes, et le potentiel de référence ($V_{ss}$), on utilise des impulsions de cadence ($Ø_{PC}$), qui sont délivrées pour leur part par la sortie d'un inverseur (I4), qui est commandé par la sortie d'une porte ET (U5), dont une entrée est commandée par la sortie de la seconde porte ET (U2) située dans la partie, commandée par l'impulsion de cadence d'adresse de ligne ($\overline{RAS}$), du dispositif de mise en forme d'impulsions et dont la seconde entrée est commandée par la sortie d'un autre inverseur (I2), dont l'entrée est chargée par les impulsions de cadence d'adresse de colonnes ($\overline{CAS}$).

9. Dispositif suivant la revendication 8, caractérisé par le fait que les impulsions délivrées par la cinquième porte ET (U5) servant à commander l'inverseur (I4) délivrant les impulsions ($Ø_{PC}$), sont prévues pour la commande d'une autre porte ET (U6), dont une entrée est raccordée directement à la sortie de la porte ET de commande (U5), tandis que la commande de la seconde entrée de l'autre porte ET (U6) est réalisée au moyen de la sortie de la porte ET (U5), moyennant l'utilisation d'un circuit de retardement (VG5), et que les impulsions ($Ø_{PC}$), qui sont nécessaires pour charger la grille du second transistor de transfert (T2) dans le décodeur raccordé à la sortie trois-états (T7, T8), peuvent être prélevées à la sortie de la porte ET commandée (U6).

10. Dispositif suivant l'une des revendications 7 à 9, caractérisé par le fait que le dispositif de mise en forme d'impulsions et en outre agencé de telle sorte que, étant chargé par l'impulsion de cadence d'adresse de ligne ($\overline{RAS}$) et l'impulsion de cadence d'adresse de colonnes ($\overline{CAS}$), il délivre également simultanément les impulsions de cadence ($Ø_D$, $Ø_c$, $Ø_c$, $\overline{Ø}_c$), nécessaires pour la commande de l'étage d'attaque de sortie de données (OL).

11. Dispositif suivant l'une des revendications 7 à 10, caractérisé par le fait que les circuits de raccordement utilisés sont réglés sur un même temps de retard.

12. Dispositif suivant la revendication 4 ou 5, caractérisé par le fait que la partie de circuit, qui relie le premier transistor de transfert (T1) et le second transistor de transfert (T2) aux transistors (T7, T8) de la sortie troisétats, ainsi que le dispositif de commande de ces deux transistors de transfert (T1, T2) sont raccordés, conformément à la figure 7, au côté source et au côté grille de ces transistors.

13. Dispositif suivant l'une des revendications 5 à 12, caractérisé par le fait que la porte ET (U), qui commande le premier transistor de transfert (T1), est formée par un transistor à effet de champ MOS (T14).

**Claims**

1. Integrated dynamic write-read memory, in which the memory matrix which consists of identical memory cells can be addressed with respect to the individual memory cells by means of at least one row decoder and one column decoder, the addressing according to the matrix columns being initiated by a column address clock $\overline{CAS}$ and the addressing according to the matrix rows being initiated by a row address clock $\overline{RAS}$ respectively, in which in addition the memory matrix has at least one redundant row and/or column which is initially excluded from the normal operation of the memory and is only available for normal operation on the basis of a special measure—and to be precise as a replacement, characterized in that the data output (DA), fed as a result of the respective addressing with the stored digital data (Do, $\overline{Do}$) and constructed as a tristate driver (T7, T8), of the memory is influenced by the output of a further circuit part (roll-call decoder) constructed as a decoder and in that this circuit part is constructed and controlled in such a way that, upon the addressing of each row or column, replaced by a redundant row or column respectively of the part (N), originally intended for normal operation, of the memory matrix (SP) and upon simultaneous external activation of the further circuit part constructed as a decoder, said circuit part brings about a blocking of the normal data path (Do, $\overline{Do}$) from the memory matrix (SP) to the tristate output (DA) and brings about the appearance of a uniform indicating signal at a signal output, in particular at the data output (DA) of the memory, said indicating signal indicating the replacement of a redundant row or column in place of the addressed row or column and in the part (N) of the memory matrix (SP) intended for normal operation.

2. Device according to Claim 1, characterized in that for reading out the addresses of defective rows a clock control, dependent only on the row address clock ($\overline{RAS}$), of the circuit part (only-RAS cycles) constructed as a decoder and acting immediately on the tristate output is used and for reading out defective columns an actuation of the row address clock ($\overline{RAS}$) and an actuation of the column address clock ($\overline{CAS}$) are used, the write pulse ($\overline{WE}$) arriving before or simultaneously with the column address clock ($\overline{CAS}$) or the delay between the two corresponding pulses of the two types ($\overline{CAS}$), ($\overline{WE}$) being set to be so small that a blocking of the normal data path from the memory matrix to the data output (DA) is ensured (early-right cycles).

3. Device according to Claim 1 or 2, characterized in that each of the redundant matrix rows (RZ) and each of the redundant matrix columns (RS) is assigned in each case to one redundancy decoder (ZDR or SDR) and the latter is constructed in such a way that due to a permanent setting of this redundancy decoder said decoder reacts to an addressing signal assigned to a defective matrix row or defective matrix column of the part (N), intended for normal operation, of the memory matrix (SP) and instead activates a redundant row or column and in addition issues a signal serving to control the tristate driver (T7, T8) forming the signal output (DA) in such a way that this signal arrives via the circuit part constructed as a decoder at the data output (DA) operating as a tristate driver (T7, T8) only in the presence of the externally triggerable activated state of an input formed by MOS field effect transistors.

4. Device according to Claim 3, characterized in that each redundancy decoder ($RZD_i$, $RSD_j$) has in each case one MOS field effect transistor ($T_{Ri}$, $T_{Cj}$) permanently assigned to it, said MOS field effect transistor being controlled by the output of said redundancy decoder at its gate and having its drain terminal connected to the first supply potential ($V_{cc}$), in that at the same time the drain terminal of these field effect transistors is connected via a clocked MOS field effect transistor (T5 or T6) to the reference potential ($V_{ss}$) and in addition is used via clocked transfer transistors (T3, T4) to control the tristate output (T7, T8).

5. Device according to Claim 4, characterized in that the MOS field effect transistor ($T_{Ri}$) assigned in each case to the individual row redundancy decoder ($ZRD_i$) is directly connected by its source terminal to the source terminal of the MOS field effect transistor ($T_{Ri}$) in each case assigned to the other row redundancy decoders ($ZRD_i$), and for the connection of the source terminals of these transistors to the reference potential ($V_{ss}$) a common MOS field effect transistor (T5) controlled by a first clock signal ($\emptyset_{PR}$) is provided in the input part of the circuit constructed as a decoder and acting on the tristate output, in that in addition the field effect transistor ($T_{Cj}$) assigned in each case to the individual column redundancy decoders ($RSD_j$) is directly connected at its source terminal to the source terminal of the MOS field effect transistor ($T_{Cj}$) in each case assigned to the other column redundancy decoders ($SRD_j$) and for the connection of these source terminals to the reference potential ($V_{ss}$) likewise a common MOS field effect transistor (T6) controlled by a second clock signal ($\emptyset_{PC}$) is provided, in that at the same time the source terminals of the MOS field effect transistors ($T_{Ri}$) controlled by the row redundancy decoders ($ZRD_i$) are commonly connected to the source terminal of a first transfer transistor (T1) controlled by the intermediate connection of an AND gate (U) fed itself with the second clock signal ($\emptyset_{PC}$) and also with a third clock signal ($\emptyset_{RC}$), and the source terminals of the MOS field effect transistors ($T_{Cj}$) controlled by the column redundancy decoders ($SRD_j$) in the input part of the circuit part constructed as a decoder are connected to the source terminal of a second transfer transistor (T2) controlled by a fourth clock signal ($\emptyset_{EC}$), in that furthermore, the drain terminals, connected to one another, of the two transfer transistors (T1, T2) are connected on the one hand to the gate, in particular also controlled by the data signal (Do, $\overline{Do}$) originating from the memory, of the output transistor (T7) connected to the first supply potential ($V_{cc}$) with the intermediate connection of a third transfer transistor (T3) controlled by the third clock signal ($\emptyset_{RC}$), whilst they are connected on the other hand via the series connection of an inverted (I) and of a fourth transfer transistor (T4) also controlled by the third clock signal ($\emptyset_{RC}$) to the gate, in particular also controlled by the inverter data signal (DO) originating from the memory, of the MOS field effect transistor (T8), connected to the reference potential ($V_{ss}$), of the two transistors (T7, T8) forming the tristate output.

6. Device according to one of Claims 1 to 5, characterized in that the information data from the memory matrix (SP) occurring at the data outputs thereof (D, $\overline{D}$) arrive at the tristate output (T7, T8) via a clock-controlled output driver (OL), in that for this purpose the data output (Do), corresponding to the direct signal, of the output driver (OL) is connected to the gate of the MOS field effect transistor (T7), connected to the first supply potential ($V_{cc}$), of the tristate output and in addition is connected via the source-drain path of a first discharge transistor (T9) to the reference potential ($V_{ss}$), in that in addition the data output ($\overline{Do}$), corresponding to the inverted data signal, of the output driver (OL) is connected to the gate of the transistor (T8), connected to the reference potential ($V_{ss}$), of the tristate output (T7, T8) and in addition is connected via a further discharge transistor (T10) to the reference potential ($V_{ss}$) and in that finally the two discharge transistors (T9, T10) are commonly controlled by the output of an AND gate (U*), the one input of which is controlled by the column address clock ($\overline{CAS}$) and the second input of which is controlled, with the intermediate connection of an inverter (I*), by the clock pulse ($\emptyset_{RC}$) which switches both the AND gate (U), the third transfer transistor (T3) and the fourth transfer transistor (T4).

7. Device according to one of Claims 4 to 6, characterized in that in order to generate the clock pulses ($\emptyset_{RC}$) necessary to control the AND gate (U) and the third and fourth transfer transistor (T3, T4) the row address clock ($\overline{RAS}$) is connected to the input of a first inverter (I1) and the output of this first inverter (I1) for controlling a first AND gate (U1) is provided in such a way that the one input of this AND gate (U1) is fed immediately by the inverter (I1) and the other input of the AND gate is fed by the inverter (I1) via a first delay member (VG1), in that furthermore the output of this first AND gate (U1) serves for feeding a second delay member (VG2) and the output of the latter serves for controlling a second AND gate (U2), the other input of which is fed immediately by the output of the first inverter (I1), and in that finally the output of the second AND gate (U2) is connected to the one input of the output AND gate (U3), supplying the desired clock pulses ($\emptyset_{RC}$) for the AND gate (U) and the gate of the third or fourth transfer transistor (T3, T4), of the clock shaper, the other input of which is controlled directly by the output of the first inverter (I1) whilst its last input is connected to the output of a Schmitt trigger (ST) which itself can be activated by an input signal (Di) deviating from the normal input level.

8. Device according to Claim 7, characterized in that clock pulses ($\emptyset_{PC}$) are used to control the MOS field effect transistor (T6) provided in the input part of the decoder and forming the connection of the transistors ($T_{Cj}$) controlled by the column redundancy decoders to the reference potential ($V_{ss}$), said pulses themselves being supplied by the output of an inverter (I4) which is controlled by the output of an AND gate (U5), the one input of which is controlled by the output of the second AND gate (U2) in the part, controlled by the row address clock ($\overline{RAS}$) of the pulse shaper and the second input of which is controlled by the output of a further inverter (I2), the input of which is fed by the column address clocks ($\overline{CAS}$).

9. Device according to Claim 8, characterized in that the pulses supplied by the fifth AND gate (U5) responsible for controlling the inverter (I4) supplying the pulses ($\emptyset_{PC}$) are provided for controlling a further AND gate (U6), in that the one input of this AND gate (U6) is connected directly to the output of the controlling AND gate (U5) whilst the control of the second input of the further AND gate (U6) occurs by means of the output of the controlling AND gate (U5) with the intermediate connection of a delay member (VG5), and in that the pulses ($\emptyset_{EC}$) required for feeding the gate of the second transfer transistor (T2) in the decoder connected to the tristate output (T7, T8) can be tapped off at the output of the controlled AND gate (U6).

10. Device according to one of Claims 7 to 9, characterized in that the pulse shaper is further constructed in such a way that on the basis of being fed with the row address clock ($\overline{RAS}$) and the column address clock ($\overline{CAS}$) said pulse shaper simultaneously also supplies the clock pulses ($\emptyset_D$, $\emptyset_o$, $\emptyset_C$, $\emptyset_C$) required for controlling the data output driver (OL).

11. Device according to one of Claims 7 to 10, characterized in that the delay members used are set to the same delay time.

12. Device according to Claim 4 or 5, characterized in that the circuit part connecting the first transfer transistor (T1) and the second transfer transistor (T2) to the transistors (T7, T8) of the tristate output and the control of these two transfer transistors (T1, T2) on their source and gate side are constructed according to Figure 7.

13. Device according to one of Claims 5 to 12, characterized in that the AND gate (U) controlling the first transfer transistor (T1) is produced by a MOS field effect transistor (T14).

# FIG 1

# FIG 2

# FIG 3

# FIG 3a

## FIG 4

$\Phi_{PC}$ = logisch "1"; $\Phi_{EC}$ = logisch "$\Phi$"; $\Phi_{C1}...\Phi_{Cj}$ = logisch "$\Phi$"

## FIG 5

# FIG 6

# FIG 7

# FIG 7a